(19) Europäisches Patentamt
European Patent Office
Office européen des brevets

(11) **EP 4 078 690 B1**

(12) **FASCICULE DE BREVET EUROPEEN**

(45) Date de publication et mention de la délivrance du brevet:
**30.08.2023 Bulletin 2023/35**

(21) Numéro de dépôt: **20833811.1**

(22) Date de dépôt: **17.12.2020**

(51) Classification Internationale des Brevets (IPC):
**H01L 31/101** (2006.01)   **H01L 31/18** (2006.01)

(52) Classification Coopérative des Brevets (CPC):
**H01L 31/109; H01L 31/101; H01L 31/1844;**
**Y02P 70/50**

(86) Numéro de dépôt international:
**PCT/EP2020/086687**

(87) Numéro de publication internationale:
**WO 2021/122931 (24.06.2021 Gazette 2021/25)**

(54) **DÉTECTEUR DE RAYONNEMENT ET PROCÉDÉ DE FABRICATION ASSOCIÉ**

STRAHLUNGSDETEKTOR UND VERFAHREN ZUR SEINER HERSTELLUNG

RADIATION DETECTOR AND CORRESPONDING MANUFACTURING METHOD

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **20.12.2019 FR 1915024**

(43) Date de publication de la demande:
**26.10.2022 Bulletin 2022/43**

(73) Titulaires:
• **THALES**
**92400 Courbevoie (FR)**
• **Commissariat à l'Energie Atomique et aux Energies Alternatives**
**75015 Paris (FR)**

(72) Inventeurs:
• **EVIRGEN, Axel**
**91767 Palaiseau (FR)**
• **REVERCHON, Jean-Luc**
**91767 Palaiseau (FR)**
• **GARCIA, Michel**
**91767 Palaiseau (FR)**
• **PARILLAUD, Olivier**
**91767 Palaiseau (FR)**
• **GERARD, Bruno**
**91767 Palaiseau (FR)**

(74) Mandataire: **Atout PI Laplace**
**Immeuble "Visium"**
**22, avenue Aristide Briand**
**94117 Arcueil Cedex (FR)**

(56) Documents cités:
**FR-A1- 3 053 836     US-A1- 2012 326 122**

• **UZGUR FATIH ET AL: "Al/Sb free InGaAs unipolar barrier infrared detectors", PROCEEDINGS OF SPIE; [PROCEEDINGS OF SPIE ISSN 0277-786X VOLUME 10524], SPIE, US, vol. 10177, 22 février 2017 (2017-02-22), pages 1017706-1017706, XP060090530, DOI: 10.1117/12.2262519 ISBN: 978-1-5106-1533-5**
• **FARSEEM M MOHAMMEDY ET AL: "Growth and fabrication issues of GaSb-based detectors", JOURNAL OF MATERIALS SCIENCE: MATERIALS IN ELECTRONICS, KLUWER ACADEMIC PUBLISHERS, BO, vol. 20, no. 11, 28 juin 2009 (2009-06-28) , pages 1039-1058, XP019730932, ISSN: 1573-482X, DOI: 10.1007/S10854-009-9927-Y**

EP 4 078 690 B1

**Description**

**DOMAINE DE L'INVENTION**

La présente invention concerne le domaine de l'imagerie pour l'infra-rouge (IR) et en particulier un détecteur de rayonnement ou photodétecteur fabriqué avec des matériaux III-V et fonctionnant à plus haute température que 80 K.

**ETAT DE LA TECHNIQUE**

Il est connu que pour obtenir des imageurs hautes performances dans le domaine de la détection l'IR, le détecteur doit fonctionner à des températures cryogéniques, ce qui nécessite la mise en place d'une circuiterie cryogénique constituée entre autre d'un cryostat et d'une machine de mise en froid.

L'une des problématiques essentielles de ces détecteurs est l'augmentation de la température de fonctionnement afin de répondre à des besoins de compacité, de fiabilité, de réduction de la consommation et des coûts de fabrication de la machine de mise en froid et du cryostat. L'objectif est de réduire la taille, le poids et la puissance de consommation de la circuiterie cryogénique mise en place autour du détecteur (critères SWaP pour « Size, Weight and Power»). Un imageur infra-rouge est constitué d'une matrice de photodétecteurs hybridée sur un circuit de lecture en silicium.

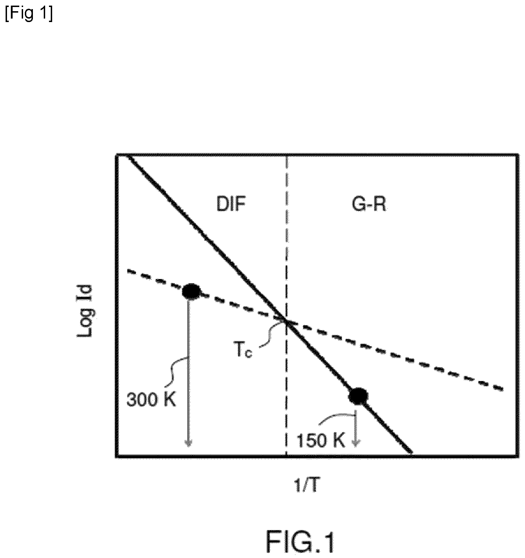

La principale grandeur physique du photodétecteur qui est liée à la température de fonctionnement est son courant d'obscurité ou « dark current » Id, c'est à dire le courant présent dans le composant en l'absence d'éclairement. La figure 1 présente les deux mécanismes limitant le courant d'obscurité Id d'un photodétecteur à la tension de polarisation en échelle logarithmique et en fonction de l'inverse de la température T: Le phénomène prédominant à basse température est le courant de génération-recombinaison dans la zone de désertion, et le phénomène dominant à plus haute température est le courant de diffusion dans les bandes plates. Les deux mécanismes se croisent pour une température Te, définissant deux zones DIF et G-R. Au-dessus de Tc (zone DIF) le courant d'obscurité est limité par les mécanismes de diffusion et en dessous de Tc (zone G-R) par les mécanismes de génération-recombinaison. Le courant GR de génération recombinaison provient de la génération des paires électron/trous par l'intermédiaire de défauts SRH (Shockley-Read-Hall) dans le gap dans les zones possédant un champ initialement située à la jonction entre la couche absorbante et le contact. Le courant de diffusion provient de la génération de paires électron/trous par l'intermédiaire de défauts SRH et/ou d'un troisième porteur de charge (effet Auger 1 ou 7) et/ou de l'absorption d'un photon (effet radiatif lié à l'équilibre thermodynamique du détecteur avec son environnement)

On cherche ainsi à réaliser un imageur HOT (High Operating Température) fonctionnant à une température supérieure à 80 K pour lequel le détecteur IR est uniquement limité par le courant de diffusion, quelque soit la gamme de température.

Par exemple dans le MWIR [$3.7\mu m$-$5\mu m$], la majorité des imageurs commercialisés actuellement sont en InSb (matériau III-V) fabriqué en technologie planaire implantée et fonctionnent autour de 80K, il ne s'agit pas d'un imageur HOT. Dans le MWIR [$3.7\mu m$-$4.1\mu m$], un imageur HOT en technologie « XBn » décrite ci-après fonctionne à 150K. Les documents EP1642345, EP2002487, EP2249400 et EP2797122 décrivent un exemple de photodétecteur HOT appelé « XBn » présentant un courant GR réduit. Il est généralement fabriqué par épitaxie par jets moléculaires (EJM) et est constitué par l'empilement suivant: X=contact InAsSb, dopage n ou p, ou GaSb dopage p / B=barrière AlGaAsSb / n=zone absorbante InAsSb. La barrière B présente le gap le plus élevé.

Ce composant diffère des traditionnelles homojonctions PN en matériau InSb car son architecture permet de confiner la zone de désertion, source d'un fort courant d'obscurité en dehors des matériaux « petit gap » tels que InAsSb (zone absorbante) et dans un matériau plus grand gap AlGaAsSb (la barrière). InAsSb est alors en régime dit « des bandes plates » en référence aux bandes d'énergie des porteurs minoritaires de la zone absorbante. L'ajustement de l'épaisseur et du dopage de la barrière B, pour un contact donné, permet à la couche absorbante de rester en « bande plate ». Le matériau petit gap (zone absorbante) reste ainsi exempt de champ électrique, ce qui permet au composant de présenter un faible courant d'obscurité et de fonctionner à 150K. Lorsque le matériau X est GaSb, la structure possède un « turn-on-voltage » (tension de polarisation) plus élevé ce qui entraine une surconsommation de l'imageur IR.

Ces composants de type XBn présentent un certain nombre d'inconvénients :

- Le matériau AlGaAsSb (barrière) est difficile à maitriser.

- Croissance et dopage : les matériaux riches en aluminium sont connus pour être de moins bonne qualité cristalline que les matériaux à base d'indium ou de gallium (présence de nombreux états d'énergie dans le gap). De plus, les conditions de croissance optimales par EJM des couches AlGaAsSb (barrière) et InAsSb (couche absorbante) sont distinctes, ce qui nécessite de réaliser des compromis. Le dopage de AlGaAsSb est également difficile à maitriser.

- Process technologique : AlGaAsSb s'oxyde facilement au contact de l'air ou de l'eau, ce qui rend le procédé technologique plus complexe. La passivation et la stabilisation de la surface d'AlGaAsSb après gravure pour obtenir un plateau peu élevé, dénommé « shallow MESA » en anglais, est délicate à mettre en place et peut être source d'inhomogénéité (risque de perte d'adhérence du diélectrique sur AlGaAsSb à cause de son oxydation, fluctuation de l'oxyde au bord des mesas pouvant entrainer des fluctuations de courant, cross-talk électrique...).

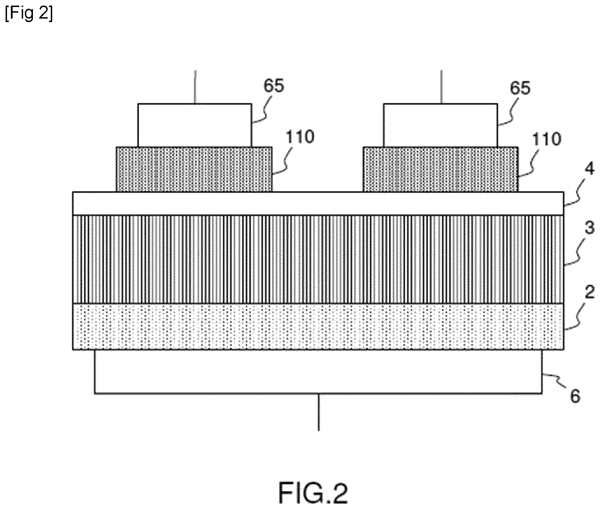

- La pixellisation se fait par gravure « shallow MESA » de la couche contact jusqu'au matériau AlGaAsSb, tel qu'illustré figure 2. Une électrode commune 2 est déposée sur le substrat 6, puis une couche absorbante 3 en InAsSb, une couche barrière 4 en AlGaAsSb et une couche de contact 110. La couche de contact 110 (dopage p) est gravée pour délimiter les pixels et reliée à des contacts métalliques 65.

- L'alignement des offsets de bandes de valence entre InAsSb, AlGaAsSb et GaSb nécessite une tension de polarisation (« Turn on voltage ») pour être en configuration de bande plate. Cette configuration à tension de polarisation non nulle peut être source d'inhomogénéité, une oxydation non contrôlée de la barrière pouvant générer une fluctuation de cette tension caractéristique

- La structure XBn ne peut pas fonctionner correctement dans un agencement matriciel avec des pixels dont le dopage est réalisé par diffusion. En effet, avec X=InAsSb étant un petit gap, il existerait un courant de fuite non négligeable selon l'axe X des zones pixel (dopées p) vers les zones interpixel (dopées n). Avec X=GaSb il faudrait appliquer une tension de polarisation supérieure du fait de l'alignement des offsets de bande de valence qui augmente la consommation de l'imageur et est susceptible de provoquer de nombreux problèmes de dépolarisation en cas de fuites dommageable à l'uniformité de la matrice.

Afin de résoudre certains de ces inconvénients, le document FR 1601065 (publié sous le numéro FR3053836 A1) propose une structure d'imageur tel qu'illustré figure 3. Cette structure présente l'avantage d'être compatible d'une pixellisation par diffusion, implantation ou recess (gravure localisée pour prendre contact avec une couche barrière enterrée) telle que décrite dans le document FR1501985 (publié sous le numéro FR3041815 A1).

Le photodétecteur comprend un empilement 201 de différents matériaux et comprenant une couche absorbante petit gap correspondant au gap le plus petit de toute la structure, une couche de charges écran C2, une couche de transition C3, une couche fenêtre C4, une couche diélectrique de passivation C7. Les couches C1 et C2 présentent un dopage d'un premier type, préférentiellement n, et la couche C4 comprend des zones P1 dopée du deuxième type p délimitant les pixels et des zones interpixel P2 dopée n.

On définit un dopage résiduel d'un matériau comme un dopage inhérent à sa fabrication et/ou à la nature chimique du matériau réalisé (ex impuretés non contrôlées), que l'on peut connaître par des mesures. Un dopage volontaire est obtenu par incorporation d'atomes dopants dans le matériau. L'incorporation peut être réalisée pendant la croissance ou après la croissance par implantation ou diffusion d'atomes dopants dans le matériau.

Le dopage n interpixel dans les zones P2 est ajusté pendant la croissance, alors que le dopage p des zones P1 est réalisé par insertion post croissance d'atomes dopant p dans la couche C4.

Une métallisation 25 réalise le contact avec la zone P1 (première électrode). Dans une telle structure, la couche absorbante C1 reste en bande plate par la gestion du dopage et de l'épaisseur de la couche de charges écran C2.

La structure des bandes des couches C1, C2, C3 et C4 est configurée pour ne pas former une barrière à un mouvement des porteurs minoritaires (qui sont les trous pour un dopage n de la couche absorbante) depuis la couche C1 jusqu'à la couche C4. Les trous circulent dans la bande de valence et les électrons dans la bande de conduction. Pour un dopage n de C1, les bandes d'intérêt sont les bandes de valence.

Les matériaux semi-conducteurs de l'empilement sont des matériaux à base de composés IIIA et VA du tableau périodique des éléments.

De l'autre côté (côté inférieur) l'empilement comprend de manière classique une couche intermédiaire C6 dopée n et un substrat C5 dopé n pour réaliser le contact n (deuxième électrode). Leur structure de bande est configurée pour ne pas présenter de barrière susceptible de s'opposer au mouvement des porteurs majoritaires (les électrons pour un dopage n de la couche absorbante) de C1 jusqu'à la deuxième électrode. Pour un dopage n de C1, les bandes d'intérêt sont les bandes de conduction.

Un exemple de cette structure est :
Couche fenêtre contact C4 en GaSb (dopage n) / couche de transition C3 en GaSb (dopage résiduel P) / couche de charge écran C2 en InAlAsSb (n) / couche absorbante C1 InAsSb (n).

La pixellisation se fait par diffusion ou implantation de dopant P dans le GaSb.

Ce type de structure présente les avantages suivants :

- pas de couche en AlGaAsSb (facilement oxydable et source de bruit)

- pixellisation par insertion de dopants, ce qui permet une fabrication simplifiée, sans gravure « shallow MESA » et de bien confiner les porteurs de charge minoritaires dans l'interpixel loin de l'interface diélectrique C7 / C4.

- pas de tension caractéristique d'établissement du courant. Cette structure fonctionne en mode photovoltaïque car les hétérostructures Gasb/InAlAsSb et InAlASb/InAsSb sont de type 2.

Néanmoins cette structure présente des inconvénients :

- la surface à passiver est le GaSb. Les matériaux à base d'antimoine sont connus pour être difficiles à passiver. Il y a des risques de fuites en surface et de cross-talk électrique au niveau des jonctions GaSb PN latérales (selon l'axe X entre zones pixel et zones interpixel).

- l'incorporation de dopants par insertion, préférentiellement par diffusion, dans le GaSb n'est pas évidente, notamment par Epitaxie en phase vapeur organique des métaux dénommé MOVPE (Metal Organic Vapor Phase Epitaxy en anglais).

Un but de la présente invention est de remédier aux inconvénients précités en proposant un détecteur de rayonnement dans l'esprit du détecteur décrit ci-dessus mais présentant une fabrication et un fonctionnement amélioré.

## DESCRIPTION DE L'INVENTION

La présente invention a pour objet un détecteur de rayonnement comprenant un empilement de couches le long d'une direction Z, ledit empilement comprenant :

- une couche absorbante configurée pour absorber le rayonnement et réalisée en un premier matériau semiconducteur présentant un premier gap et un dopage d'un premier type,

- une première couche de contact réalisée en un deuxième matériau présentant un deuxième gap strictement supérieur au premier gap,

- un ensemble d'au moins une couche intermédiaire dénommé ensemble intermédiaire, disposé entre la couche absorbante et la première couche de contact, chaque couche intermédiaire étant réalisée en un matériau intermédiaire semiconducteur présentant un gap intermédiaire supérieur ou égal au premier gap,

- une couche supérieure disposée sur la première couche de contact du côté opposé audit ensemble intermédiaire, réalisée en un troisième matériau semiconducteur présentant un troisième gap strictement supérieur à tous les autres gaps de l'empilement,

- la première couche de contact et la couche supérieure présentant une pluralité de zones de détection et de zones de séparation, une zone de séparation séparant une zone de détection d'une autre zone de détection, chaque zone de détection étant entourée par une zone de séparation dans un plan perpendiculaire à Z, une zone de détection correspondant à un pixel dudit détecteur, les deuxième et troisième matériaux étant configurés pour présenter un dopage d'un deuxième type dans les zones de détection et un dopage du premier type dans les zones de séparation,

- lorsque le premier type de dopage est n, une bande de valence du premier matériau est strictement inférieure à une bande de valence du deuxième matériau dans les zones de détection, et la ou les bandes de valence du ou des matériaux intermédiaires sont comprise(s) entre la bande de valence du premier matériau et la bande de valence du deuxième matériau dans les zones de détection, et sont configurée(s) pour varier de manière monotone croissante dans le sens couche absorbante vers première couche de contact,

- lorsque le premier type de dopage est p, une bande de conduction du premier matériau est strictement supérieure à une bande de conduction du deuxième matériau dans les zones de détection, et la ou les bandes de conduction du ou des matériaux intermédiaires sont comprise(s) entre la bande de conduction du premier matériau et la bande de conduction du deuxième matériau dans les zones de détection , et sont configurée(s) pour varier de manière monotone décroissante dans le sens couche absorbante vers première couche de contact,

- une couche de passivation réalisée en un matériau diélectrique, disposée sur la couche supérieure, et présentant des ouvertures au niveau des zones de détection de la couche supérieure,

- les couches semiconductrices de l'empilement étant des composés à base d'éléments des colonnes IIIA et VA du tableau périodique des éléments, le deuxième matériau comprenant l'élément VA antimoine et le troisième matériau étant dépourvu de l'élément VA antimoine.

Selon un mode de réalisation : lorsque le premier type de dopage est n, la ou les bande(s) de valence du ou des matériaux intermédiaires sont inférieure(s) à la bande de conduction du deuxième matériau ; lorsque le premier type de dopage est p, la ou les bande(s) de conduction du ou des matériaux intermédiaires sont supérieure(s) à la bande de valence du deuxième matériau.

Selon un mode de réalisation, à l'interface (12) entre la couche supérieure et la couche de contact dans les zones de détection : lorsque le premier type de dopage est n, la bande de valence du troisième matériau est située en dessous de la bande de valence du deuxième matériau et la bande de conduction du troisième matériau est située au-dessus de la bande de conduction du deuxième matériau ; lorsque le premier type de dopage est p, la bande de conduction du troisième matériau est située au-dessus de la bande de conduction du deuxième matériau et la bande de valence du troisième matériau est située en dessous de la bande de valence du deuxième matériau.

Selon un mode de réalisation détecteur de rayonnement selon l'une des revendications précédentes dans lequel le troisième matériau est de type III-As.

Selon un mode de réalisation le deuxième matériau est GaSb et le troisième matériau est InGaAs. Préférentiellement le pourcentage d'indium du troisième matériau est inférieur à 50%.

Selon un mode de réalisation le détecteur comprend en outre :

- une deuxième couche de contact disposée sous la couche absorbante et du côté opposé à la couche intermédiaire, réalisée en un quatrième matériau semiconducteur présentant un quatrième gap strictement supérieur au premier gap et un dopage du premier type,

- un substrat sur lequel est déposée la deuxième couche de contact.

Selon une variante le dopage de deuxième type des zones de détection est obtenu par une incorporation d'atomes dopants dans la couche de contact et la couche supérieure, effectuée postérieurement à la croissance desdites couche de contact et couche supérieure, et via lesdites ouvertures.

Selon un mode de réalisation la couche supérieure et la première couche de contact présentent, dans les zones de détection, et sur toute leur épaisseur respective, une quantité d'atomes dopants supérieure à $10^{17}$ atomes/cm$^3$.

Selon un autre aspect l'invention concerne un procédé de réalisation d'un détecteur de rayonnement comprenant :

- une étape de réalisation d'un empilement de couches le long d'une direction Z sur un substrat comprenant :

  --une couche absorbante configurée pour absorber le rayonnement et réalisée en un premier matériau semiconducteur présentant un premier gap et un dopage d'un premier type,

  --une première couche de contact réalisée en un deuxième matériau présentant un deuxième gap strictement supérieur au premier gap,

  --une deuxième couche de contact réalisée en un quatrième matériau semiconducteur présentant un quatrième gap strictement supérieur au premier gap et un dopage du premier type, disposée entre le substrat et la couche absorbante,

  --un ensemble d'au moins une couche intermédiaire dénommé ensemble intermédiaire, disposé entre la couche absorbante et la première couche de contact, chaque couche intermédiaire étant réalisée en un matériau intermédiaire semiconducteur présentant un gap intermédiaire supérieur au premier gap,

  --une couche supérieure disposée sur la première couche de contact du côté opposé audit ensemble intermédiaire, réalisée en un troisième matériau semiconducteur présentant un troisième gap strictement supérieur à tous les autres gaps de l'empilement,

  --une couche de passivation réalisée en un matériau diélectrique, disposée sur la couche supérieure,

  --les couches semiconductrices de l'empilement étant des composés à base d'éléments des colonnes IIIA et VA du tableau périodique des éléments, le deuxième matériau comprenant l'élément VA antimoine et le troisième matériau étant dépourvu de l'élément VA antimoine,

--le deuxième et troisième matériau étant configurés pour présenter un dopage du premier type,

- une étape de formation d'ouvertures dans la couche de passivation,

- une étape d'incorporation d'atomes dopants dans la première couche de contact et dans la couche supérieure via les ouvertures, de manière à former des zones de détection présentant un deuxième type de dopage, les zones de détection étant séparées par des zones de séparation séparant une zone de détection d'une autre zone de détection, chaque zone de détection étant entourée par une zone de séparation dans un plan perpendiculaire à Z, une zone de détection correspondant à un pixel dudit détecteur, les deuxième et troisième matériaux présentant alors un dopage du deuxième type dans les zones de détection et un dopage du premier type dans les zones de séparation,

- une étape (400) de métallisation au travers des ouvertures (Op) pour former une première électrode (E1).

Selon une variante l'étape d'incorporation d'atomes dopants s'effectue par diffusion.

Selon un mode de réalisation le premier type de dopage est n et l'atome dopant incorporé est le Zinc.

Selon un mode de réalisation le procédé selon l'invention comprend en outre, après l'étape de métallisation, une étape de connexion d'un circuit de lecture audit empilement via ladite première électrode.

Selon un mode de réalisation le procédé comprend en outre, après l'étape de réalisation de l'empilement, une étape de collage d'un circuit de lecture audit empilement, l'étape de formation des ouvertures s'effectuant alors au travers du circuit de lecture.

La description suivante présente plusieurs exemples de réalisation du dispositif de l'invention : ces exemples sont non limitatifs de la portée de l'invention. Ces exemples de réalisation présentent à la fois les caractéristiques essentielles de l'invention ainsi que des caractéristiques additionnelles liées aux modes de réalisation considérés.

L'invention sera mieux comprise et d'autres caractéristiques, buts et avantages de celle-ci apparaîtront au cours de la description détaillée qui va suivre et en regard des dessins annexés donnés à titre d'exemples non limitatifs et sur lesquels :

[Fig 1] La figure 1 déjà citée illustre l'évolution du courant d'obscurité en fonction de la température.

[Fig 2] La figure 2 déjà citée illustre la méthode de pixellisation par gravure dite « shallow MESA ».

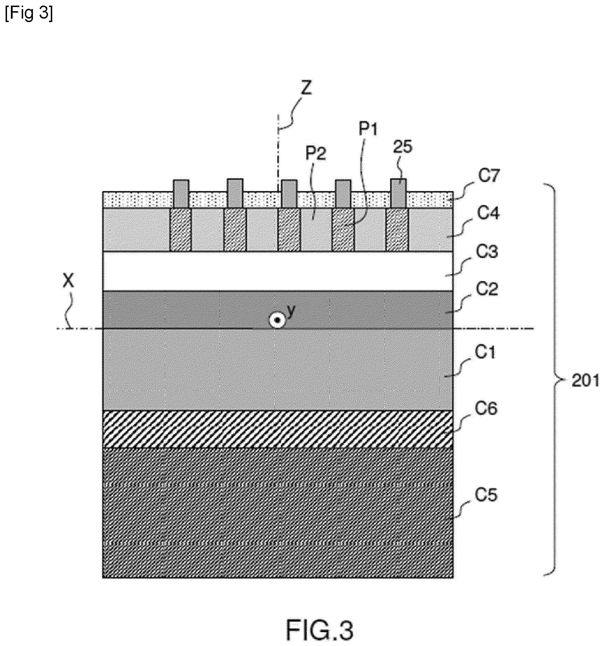

[Fig 3] La figure 3 déjà citée illustre un photodétecteur selon l'état de la technique.

[Fig 4] La figure 4 illustre l'empilement d'un détecteur de rayonnement selon l'invention.

[Fig 5] La figure 5 illustre une variante préférée d'un empilement d'un détecteur de rayonnement selon l'invention.

[Fig 6] La figure 6 illustre la structure des bandes d'énergie d'un empilement d'un détecteur de rayonnement selon l'invention comprenant une couche intermédiaire unique. La figure 6a illustre le diagramme de bandes dans la zone pixel (Zdet) et la figure 6b dans la zone interpixel (Zsep).

[Fig 7] La figure 7 illustre la structure des bandes d'énergie d'un empilement d'un détecteur de rayonnement selon l'invention comprenant une couche intermédiaire avec un gradient de concentration. La figure 7a illustre le diagramme de bandes dans la zone pixel (Zdet) et la figure 7b dans la zone interpixel (Zsep).

[Fig 8] La figure 8 illustre la structure des bandes d'énergie d'un empilement d'un détecteur de rayonnement selon l'invention comprenant deux couches intermédiaires. La figure 8a illustre le diagramme de bandes dans la zone pixel (Zdet) et la figure 8b dans la zone interpixel (Zsep).

[Fig 9] La figure 9 illustre la concentration en atomes de Zn incorporés par diffusion dans une couche de GaSb.

[Fig 10] La figure 10 illustre la concentration en atomes de Zn incorporés par diffusion dans une couche de GaSb précédée d'une couche superficielle en InAsSb.

[Fig 11] La figure 11 illustre le diagramme de bandes simulé d'un exemple d'empilement d'un détecteur selon l'invention.

[Fig 12] La figure 12 illustre le procédé de réalisation d'un détecteur de rayonnement selon un autre aspect de l'invention.

[Fig 13] La figure 13 illustre une première variante du procédé de réalisation d'un détecteur de rayonnement selon l'invention.

[Fig 14] La figure 14 illustre un détecteur selon l'invention réalisé par la première variante du procédé selon l'invention.

[Fig 15] La figure 15 illustre une deuxième variante du procédé de réalisation d'un détecteur de rayonnement selon l'invention.

[Fig 16] La figure 16 illustre un détecteur selon l'invention réalisé par la deuxième variante du procédé selon l'invention.

## DESCRIPTION DETAILLEE DE L'INVENTION

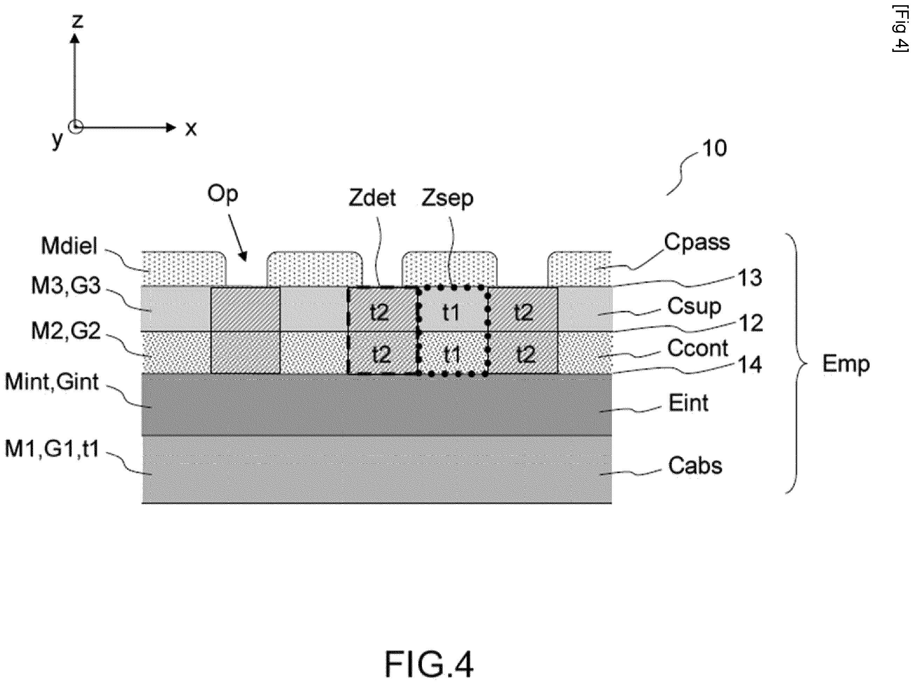

La figure 4 illustre un détecteur de rayonnement 10 selon l'invention comprenant un empilement Emp de couches le long d'une direction Z. L'empilement comprend une pluralité de couche semiconductrices et une couche diélectrique. Les couches semiconductrices de l'empilement sont des composés (binaire, ternaire, quaternaire) à base d'éléments des colonnes IIIA et VA du tableau périodique des éléments. La colonne IIIA comprend: B, Al, Ga, In et la colonne VA comprend : N, P, As, Sb, Bi.

Le détecteur 10 comprend une couche absorbante Cabs configurée pour absorber le rayonnement, préférentiellement IR, préférentiellement dans les domaines SWIR, MWIR ou LWIR, et réalisée en un premier matériau M1 semiconducteur présentant un premier gap G1 et un dopage d'un premier type t1. Le premier type de dopage est n ou p. Préférentiellement mais non limitativement le premier type de dopage est n.

Le dopage (densité volumique de dopants) de M1 est typiquement assez faible, de l'ordre de $10^{14}$ à $5.10^{16}$ atomes /cm$^2$. Le matériau M1 de Cabs est par exemple $In_XGa_{1-X}As_YSb_YBi_{1-Y-Z}$ $0 \leq X,Y,Z \leq 1$ ou un super réseau (SR). $In_{X1}Ga_{1-x1}As_{Y1}Sb_{Y1}Bi_{1-Y1-Z1}$/ $In_{X2}Ga_{1-X2}As_{Y2}Sb_{Y2}Bi_{1-Y2-Z2}$, $0 \leq X1, X2,Y1, Y2, Z1, Z2 \leq 1$

Le détecteur comprend également une première couche de contact Ccont réalisée en un deuxième matériau M2 présentant un deuxième gap G2 strictement supérieur au premier gap G1.

Le matériau M2 de Ccont est préférentiellement en matériaux $Al_{X3}Ga_{1-X3}Sb_{Y3}As_{1-Y3}$, Préférentiellement, $0 \leq X3 \leq 0.4$ et $0.96 < Y3 \leq 1$. La première couche de contact Ccont comprend toujours l'élément VA antimoine Sb afin d'être proche de l'accord de maille avec le substrat sur lequel est réalisé l'empilement, qui est préférentiellement le GaSb (filière technologique GaSb). Etre proche de l'accord de maille permet d'éviter les dislocations qui dégradent le matériau. Préférentiellement toutes les couches depuis le substrat jusqu'à Ccont comprennent de l'antimoine pour cette même raison. Préférentiellement la couche Ccont présente une épaisseur comprise entre 50nm et 300nm.

L'empilement comprend également un ensemble d'au moins une couche intermédiaire Cint, dénommé ensemble intermédiaire Eint, disposé entre la couche absorbante Cabs et la première couche de contact Ccont. Chaque couche intermédiaire indicée i Cinti est réalisée en un matériau intermédiaire Minti semiconducteur présentant un gap intermédiaire Ginti supérieur ou égal au premier gap G1 :

Ginti $\geq$ G1 quel que soit i.

L'indice i varie de 1 à n, i=1 correspondant à la couche intermédiaire adjacente à la couche absorbante.

L'ensemble intermédiaire Eint a pour objet de permettre l'extraction et le transport des porteurs minoritaires de la couche absorbante Cabs vers la couche de contact Ccont. Préférentiellement pour obtenir hors éclairement un faible courant d'obscurité l'épaisseur et le dopage de la couche intermédiaire Cint1 en contact avec la couche absorbante sont déterminées pour obtenir la configuration « bandes plates ».

L'empilement comprend également une couche supérieure Csup disposée sur la première couche de contact Ccont du côté opposé à l'ensemble intermédiaire, réalisée en un troisième matériau M3 semiconducteur présentant un troisième gap G3 strictement supérieur à tous les autres gaps de l'empilement. La couche supérieure Csup est dépourvue de l'élément VA antimoine Sb. La présence de cette couche supérieure Csup dépourvue d'antimoine permet de réaliser un empilement optimisé et un photodétecteur au fonctionnement amélioré, comme expliqué plus loin.

La première couche de contact Ccont et la couche supérieure Csup présentent une pluralité de zones de détection Zdet et de zones de séparation Zsep communes aux deux couches. Une zone de séparation sépare une zone de détection d'une autre zone de détection, chaque zone de détection étant entourée par une zone de séparation dans un plan perpendiculaire à Z. Une zone de détection Zdet correspond à un pixel du détecteur. Les matériaux M2 (de Ccont) et M3 (de Csup) sont configurés pour présenter un dopage du deuxième type t2 dans les zones de détection et un dopage du premier type t1 dans les zones de séparation.

Lorsque le premier type de dopage est n, le deuxième type de dopage est p et réciproquement.

Afin de réaliser l'extraction des porteurs minoritaires dans les pixels, des conditions sur les niveaux relatifs des bandes dans lesquelles circulent ces porteurs sont nécessaire. Lorsque t1 = n, les porteurs minoritaires sont les trous qui circulent dans les bandes de valence et lorsque t1 =p les porteurs minoritaires sont les électrons qui circulent dans les bandes de conduction.

Ainsi lorsque le premier type de dopage est n il faut que M2 soit configuré dans les zones de détection de sorte que la bande de valence de M1 soit strictement inférieure à la bande de valence de M2 :
BVabs<BVcont (dans Zdet)

Il faut que également que :

$$BVabs<BVint(i)<BVint(i+1)<BVcont \text{ (dans Zdet)}$$

soit que la ou les bandes de valences BVinti du ou des matériaux intermédiaires Minti soient comprise(s) entre la bande de valence du premier matériau BVabs et la bande de valence du deuxième matériau BVcont dans les zones de détection, et soient configurée(s) pour varier de manière monotone croissante dans le sens couche absorbante Cabs vers première couche de contact Ccont.

De même lorsque le premier type de dopage est p il faut que :
BCabs>BCcont (dans Zdet)

Il faut également que :

$$BCabs>BCint(i)>BCint(i+1)>BCcont$$

soit que la ou les bandes de conduction BCinti (également dénommé BCint(i)) du ou des matériaux intermédiaires soient comprise(s) entre la bande de conduction du premier matériau BCabs et la bande de conduction du deuxième matériau BCcont, et soient configurée(s) pour varier de manière monotone décroissante dans le sens couche absorbante Cabs vers première couche de contact Ccont.

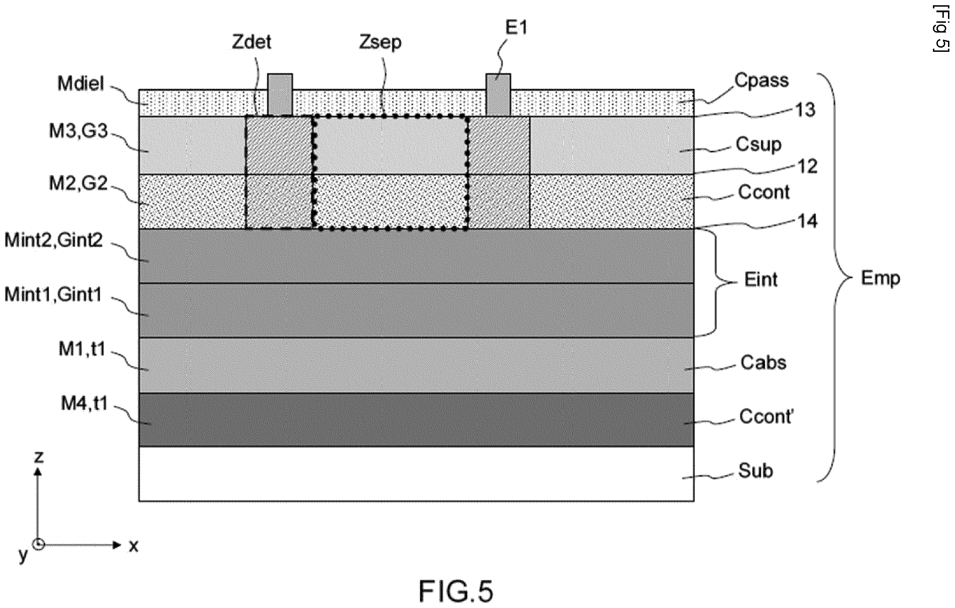

L'empilement Emp comprend également une couche de passivation Cpass réalisée en un matériau diélectrique Mdiel, disposée sur la couche supérieure Csup, et présentant des ouvertures Op au niveau des zones de détection de la couche supérieure. Une fraction de la zone de détection de Csup est destinée à être en contact électrique avec une première électrode E1, le contact s'effectuant par une métallisation au travers des ouvertures Op tel qu'illustré figure 5, qui représente une variante de l'empilement du détecteur une fois l'électrode E1 réalisée.

On dénomme 12 l'interface entre Ccont et Csup, 13 l'interface entre Csup et Cpass et 14 l'interface entre la dernière couche intermédiaire et Ccont.

La fonction de Csup est d'améliorer la passivation de la surface de la couche de contact Ccont et des jonctions latérales selon X entre les zones dopées n et les zones dopées p de la couche de contact.

Comme expliqué plus haut la couche de contact Ccont comprend de l'antimoine, dont l'oxydation est difficile à maîtriser : l'antimoine Sb s'oxyde et capte les impuretés. Il est difficile d'avoir une interface propre entre la couche de contact Ccont et une couche diélectrique de passivation.

La couche supérieure Csup est dépourvue d'antimoine pour éviter les inconvénients explicités ci-dessus. Elle est ainsi plus facile à passiver. Son grand gap G3, plus grand gap de la structure, permet en outre de réduire l'influence des jonctions PN latérales (selon X sur les figures 4 et 5) entre zones de pixel (Zdet) et zones d'interpixel (Zsep) de M2 (Ccont). Ces jonctions se retrouvent éloignées de l'interface 13 avec la couche Cpass du fait de la présence de Csup.

Préférentiellement l'épaisseur Csup est inférieure ou égale à 50 nm. En effet Csup ne comprenant pas de Sb elle n'est pas accordée en maille sur la couche Ccont, et ne doit donc pas excéder une certaine épaisseur.

Préférentiellement le troisième matériau M3 de la couche supérieure Csup est de type III-As, c'est-à-dire qu'il comprend, comme élément VA, l'arsenic à l'exclusion de tout autre élément de cette colonne. La réalisation de la couche III-As bénéficie de la grande maturité de la filière arséniure. Par ailleurs la diffusion de dopants Zn dans ce type de couche est bien maitrisée, elle est stable et résulte dans des niveaux de dopage élevés.

Un exemple de couple (M2 de Ccont, M3 de Csup) est :
M2= GaSb et M3=InGaAs.

Préférentiellement le pourcentage d'indium de Csup en InGaAs est inférieur à 50% car pour un pourcentage supérieur le gap est plus petit.

Préférentiellement et de manière classique l'empilement Emp du détecteur de rayonnement selon l'invention comprend également, tel qu'illustré également sur la figure 5, une deuxième couche de contact Ccont' disposée sous la couche absorbante et du côté opposé à la couche intermédiaire et un substrat Sub sur lequel est déposée la deuxième couche de contact. Le substrat Sub et la couche Ccont' sont transparentes au rayonnement incident.

La deuxième couche de contact Ccont' est réalisée en un quatrième matériau M4 semiconducteur présentant un quatrième gap G4 strictement supérieur au premier gap G1 et présente un dopage du premier type t1 typiquement supérieur à $10^{17}$ atomes/cm$^3$. La deuxième couche de contact Ccont' est typiquement commune à tous les pixels et destinée à être connectée à une deuxième électrode E2 (non représentée).

Préférentiellement pour un dopage t1 = n, la bande valence de Ccont' est inférieure à la bande de valence de la couche absorbante et/ou l'interface entre Ccont' et Cabs est de type II. Préférentiellement le matériau M4 de Ccont' est $In_XGa_{1-X}As_YSb_YBi_{1-Y-Z}$ $0 \leq X, Y, Z \leq 1$.

Typiquement le substrat Sub est en GaSb, et dopé du premier type (moins de dislocations) avec un dopage supérieur à $10^{18}$ atomes/cm$^3$.

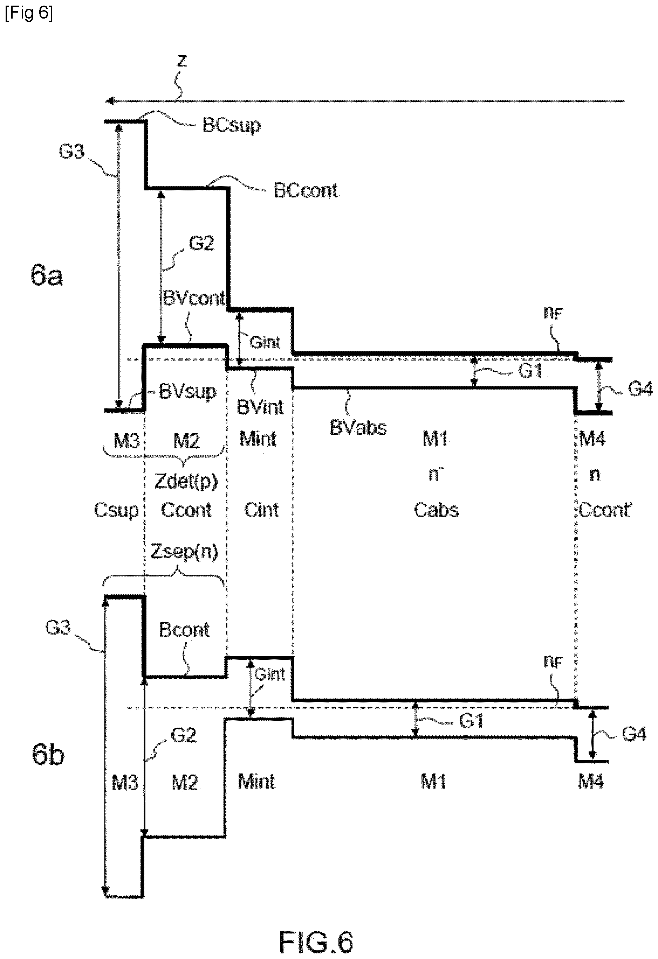

Les figures 6 à 8 illustrent trois exemples de structure de bandes (Energie E en eV en fonction de z le long de l'axe Z) schématique de l'empilement selon l'invention pour un premier type de dopage n pour la couche absorbante. Les figures 6a, 7a et 8a illustrent la structure de bandes de l'empilement et pour la zone Zdet de M2 et M3 (dopées p) et les figures 6b, 7b et 8b illustrent la structure de bandes pour la zone Zsep de M2 et M3 (dopées n). Le dopage n ou p apparaît clairement avec le positionnent du niveau de Fermi $n_F$.

La figure 6 illustre le cas d'une couche intermédiaire unique Cint.

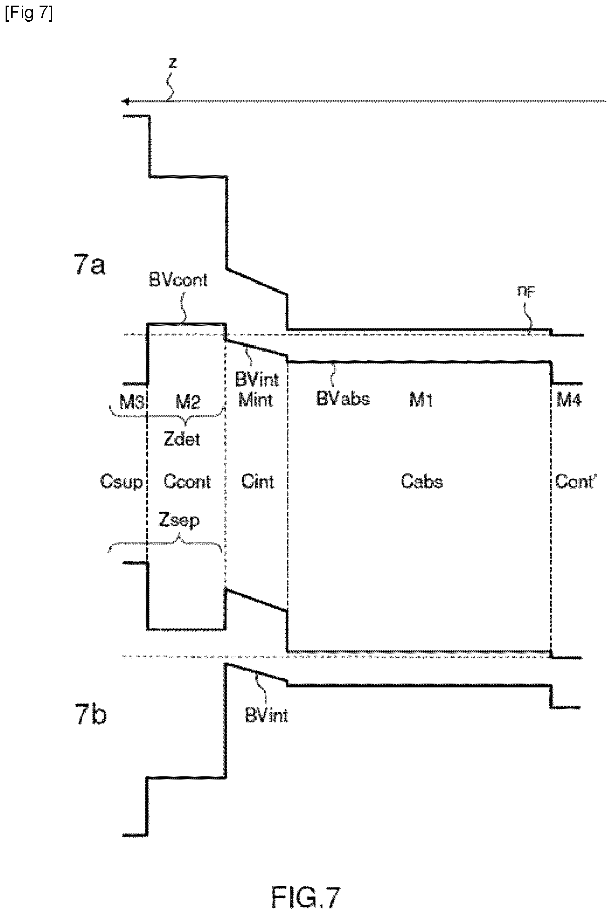

La figure 7 illustre le cas d'une couche intermédiaire présentant un gradient de concentration de manière à faire varier continûment et de façon croissante la bande de valence

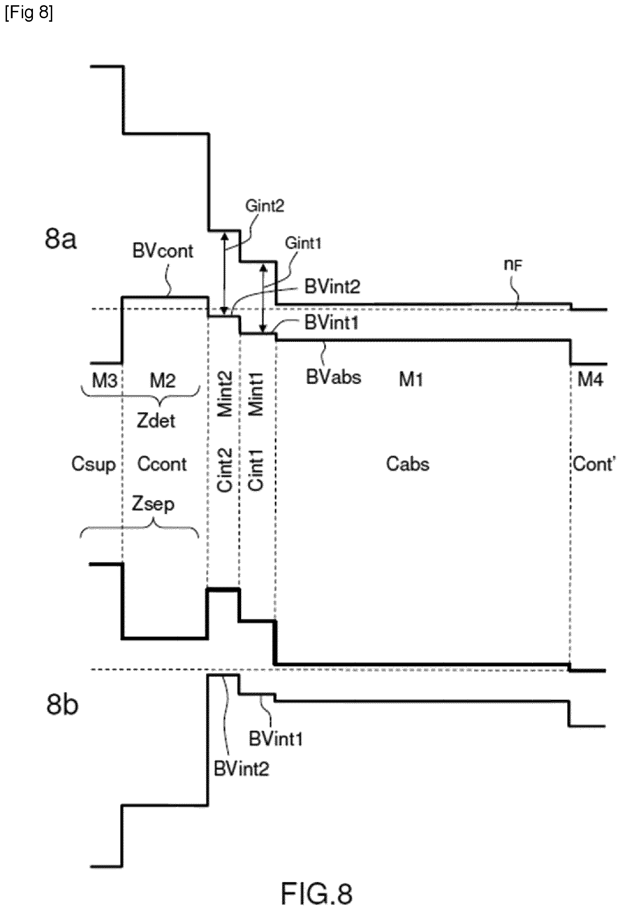

La figure 8 illustre le cas de deux couches intermédiaires discrètes Cint1 et Cint2.

Un exemple de couple (Cint1, Cint2) est :

- une couche Cint 1 en matériau Mint1 : $In_{x1}GaAs_{y1}Sb$,

- une couche Cint2 en matériau Mint2 : $InAl_{x2}As_{y2}Sb$,

avec x1, x2, y1 et y2, déterminés pour que dans les zones Zdet dopées p :

BVabs < BVint1 < BVint2 < BVcont

Une combinaison de couches intermédiaires discrètes et à gradient est bien entendu possible, à condition de respecter la condition de croissance monotone des différentes valeurs des bandes de valences.

On remarque sur les figures 6 à 8 qu'il n'y a aucun offset de bande de valence qui peut entraver le transport des porteurs minoritaires de M1 jusqu'à M2. A l'inverse, dans les zones interpixel Zsep, les porteurs restent bien confinés dans le matériau M1 et ne sont pas susceptibles de s'approcher de l'interface 13 avec le diélectrique de plus les jonctions M2-pixel/ M2-interpixel sont éloignées de cette même surface.

Préférentiellement pour t1 = n la ou les bande(s) de valence BVinti (également dénommé BVint(i)) du ou des matériaux intermédiaires est inférieure(s) à la bande de conduction BCcont de la première couche de contact pour éviter une jonction Esaki, et ce dans les deux zones Zdet et Zsep:

BVint(i)<BCcont

De même pour t1 =p la ou les bande(s) de conduction BCinti du ou des matériaux intermédiaires sont supérieure(s) à la bande de valence de la première couche de contact BVcont :

BCint(i)> BVcont

Préférentiellement à l'interface 12 entre la couche supérieure Csup et la couche de contact Ccont :

- lorsque le premier type de dopage est n, la bande de valence du troisième matériau BVsup est située en dessous de la bande de valence du deuxième matériau BVcont et la bande de conduction du troisième matériau BCsup est située au-dessus de la bande de conduction du deuxième matériau BCcont (pour les deux zones Zdet et Zsep),

- lorsque le premier type de dopage est p, la bande de conduction BCsup du troisième matériau M3 est située au-dessus de la bande de conduction BCcont du deuxième matériau M2, et la bande de valence BVsup du troisième matériau M3 est située en dessous de la bande de valence BVcont du deuxième matériau.

En d'autres termes l'interface Ccont/Csup est de type 1. A noter qu'il s'agit bien d'une condition à l'interface entre deux matériaux semiconducteurs de formule chimique différente. Cependant au-delà de l'interface à l'intérieur de chaque couche, les bandes peuvent évoluer de manière à ce que la condition ci-dessus ne soit pas vérifiée (niveau de Fermi associé au dopage).

Cette condition sur les valeurs respectives des bandes de M2 et M3 permet d'empêcher les électrons et les trous de la couche de contact Ccont de s'approcher de la surface 13 en contact avec la couche de passivation diélectrique Cpass pour éviter qu'ils se recombinent à cette interface. Ce canal augmenterait drastiquement le courant d'obscurité.

Selon une variante préférée le dopage de deuxième type des zones de détection est obtenu par une incorporation d'atomes dopants Ad dans la couche de contact et la couche supérieure, effectuée postérieurement à la croissance desdites couches de contact Ccont et couche supérieure Csup, et via lesdites ouvertures Op.

Préférentiellement le dopage de Ccont doit rester supérieur à $10^{17}$cm$^{-3}$ dans toute son épaisseur, et des niveaux de $10^{18}$cm$^{-3}$ ou $10^{19}$cm$^{-3}$ sont technologiquement aisément accessibles sur la partie de Ccont du côté de l'apport d'atomes dopants. Préférentiellement Ccont présente une épaisseur de l'ordre de 100 à 500nm pour supporter la diffusion de métal lors de la formation de contact.

Dans ce cas on s'arrange pour que, lors de la croissance, les couches Ccont et Csup présentent un dopage (résiduel ou volontaire) du premier type, qui correspond donc au dopage des zones de séparation.

Selon un mode de réalisation préféré l'incorporation de Ad est effectuée par diffusion. Alternativement elle est effectuée par implantation ionique.

Pour le cas d'une incorporation par diffusion, la couche Csup présente une deuxième fonctionnalité, celle de favoriser l'incorporation des atomes dopants dans la couche Ccont. La couche supérieure est alors dénommée « couche de pompage ».

Pour cela l'atome Ad doit être suffisamment soluble dans la couche Csup. Préférentiellement cette solubilité est au moins égal à $10^{18}$ atomes dopants par cm$^3$.

Lors d'une incorporation par diffusion d'atomes dopants, il y a une diminution du nombre d'atomes dopants en fonction de l'épaisseur de couche traversée.

Préférentiellement la couche supérieure Csup et la première couche de contact Ccont présentent dans les zones de détection, et sur toute leur épaisseur respective, une quantité d'atomes dopants Ad supérieure ou égale à $10^{17}$ atomes/cm$^3$, de manière à compenser, sur l'ensemble de l'épaisseur de Ccont, le dopage initial du premier type et obtenir par diffusion dans les zones de détection un dopage du deuxième type.

Préférentiellement Csup et une partie de Ccont du côté de Csup (côté d'arrivée des atomes dopants) présentent, dans les zones de détection, une quantité d'atomes dopants Ad supérieure à $10^{19}$ atomes/cm$^3$, préférentiellement supérieure à $10^{20}$ atomes/cm$^3$.

Lorsque t1 = n et t2=p, le dopage p des zones de détection est préférentiellement obtenu par incorporation d'atomes de Zinc. Par exemple le zinc présente une bonne solubilité dans le GaSb, typiquement de $10^{20}$ atomes/cm$^3$.

Lorsque t1=p et t2=n, selon une option le dopage n des zones de détection est obtenu par incorporation d'atomes tellure ou germanium, pour Ccont en GaSb et Csup en III-As.

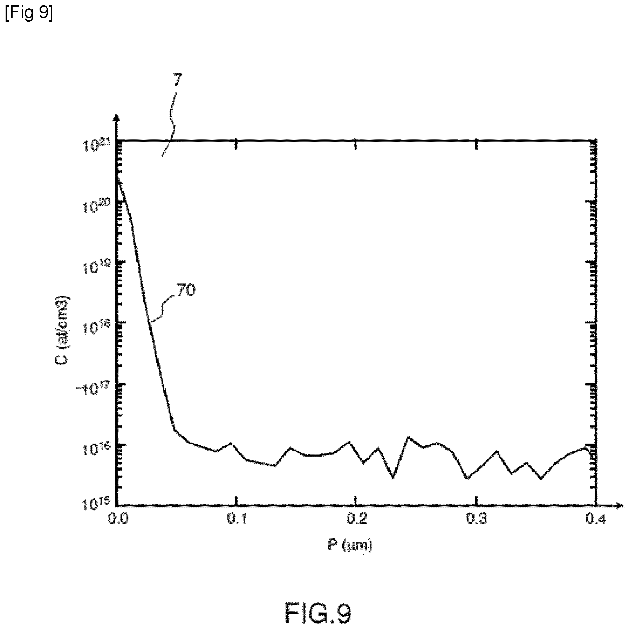

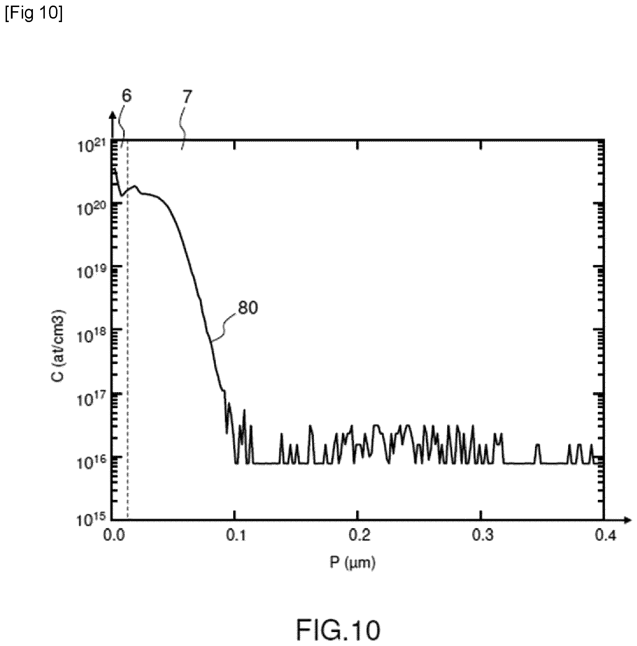

Pour illustrer la fonction de pompage de Csup précité, les figures 9 et 10 illustrent respectivement la concentration C d'atomes dopants Zinc en fonction de la profondeur P dans le matériau lors d'une diffusion par MOVPE du Zn dans une couche 7 de GaSb seul (courbe 70, figure 9) et précédée d'une couche superficielle 6 d'InGaAs de 10 nm (courbe 80, figure 10), (mesures en spectroscopie de masse par ions secondaires dénommé SIMS pour Secondary Ion Mass Spectroscopy en anglais). En comparant les deux courbes 70 et 80 on observe que le front est plus homogène et le niveau de dopage plus élevé dans la couche 7 en GaSb lorsque la diffusion s'est faite en présence de la couche d'InGaAs.

L'objet de la couche supérieure Csup selon l'invention est ainsi de favoriser la diffusion dans la couche Ccont en pompant les atomes dopants, tout en présentant un gap plus grand que la couche de contact Ccont typiquement en GaSb. Un exemple est une couche Csup de quelques dizaines de nanomètres de ternaire $In_xGa_{(1-x)}$As avec x tel que le gap de cette couche soit supérieur au gap de GaSb. Le substrat étant préférentiellement également en GaSb, ce matériau InGaAs est en désaccord de maille et doit donc avoir une épaisseur suffisamment faible.

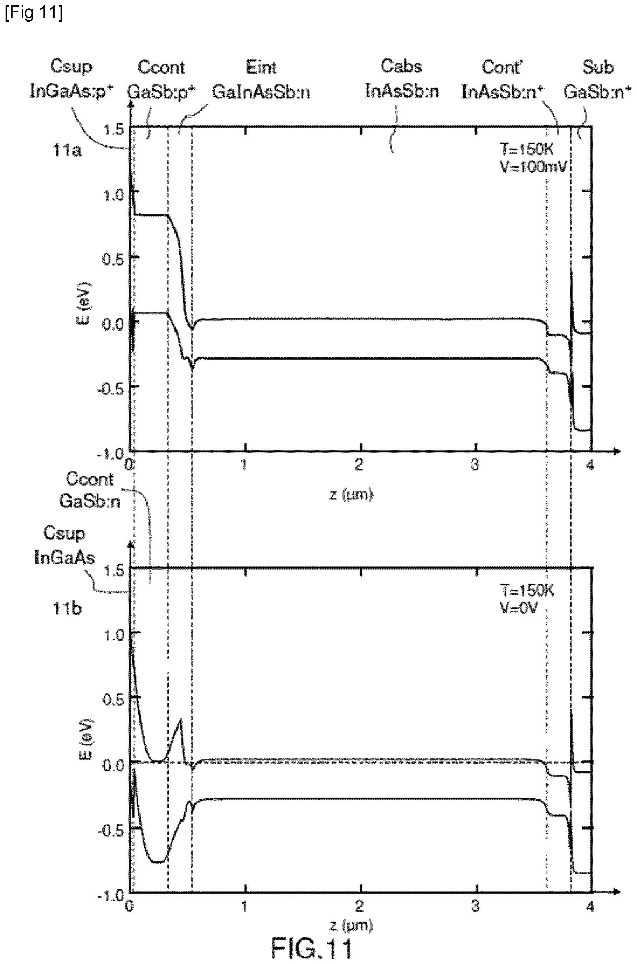

Une simulation de la structure de bandes d'un exemple d'empilement selon l'invention est illustrée figure 11.

La figure 11a illustre une zone pixel (Zdet) et la figure 11b une zone interpixel (Zsep) :

La couche Cabs est en InAsSb dopé n, la couche Ccont' en InAsSb dopé n$^+$, le substrat en GaSb dopé n$^+$, l'ensemble intermédiaire est constitué d'une couche en GaInAsSb dopée n dans laquelle un gradient des bandes de valence dans la zone pixel est obtenu par variation de la composition chimique des différents atomes. Dans la zone pixel, la couche Ccont est en GaSb dopé p$^+$ et la couche Csup en InGaAs dopé p$^+$. Dans la zone interpixel la couche Ccont est en GaSb dopé n (dopage volontaire) et la couche Csup en InGaAs. Un dopage p ou n correspond typiquement à un dopage jusqu'à $10^{17}$cm$^{-3}$, un dopage p+ ou n+ à un dopage au delà de $10^{17}$cm$^{-3}$.

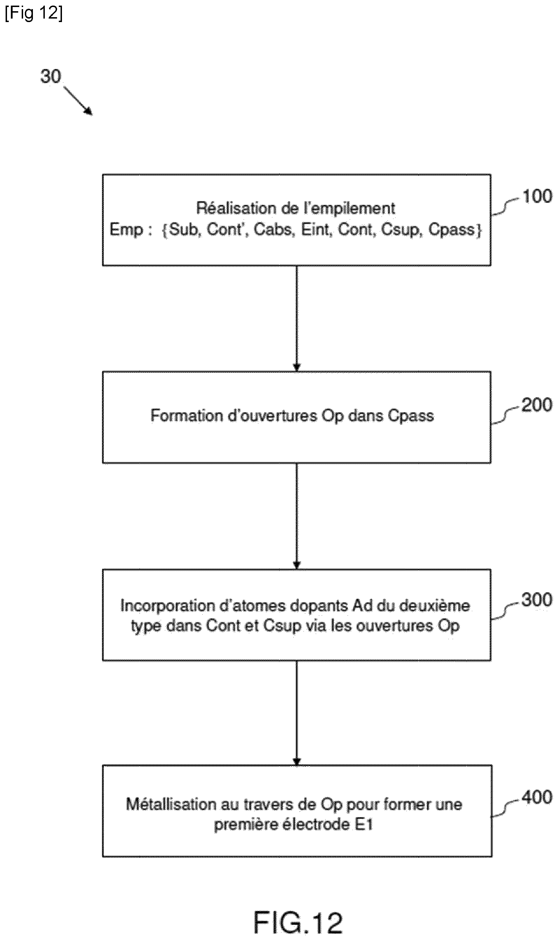

Selon un autre aspect l'invention concerne un procédé 30 de réalisation d'un détecteur de rayonnement illustré figure 12 comprenant une première étape 100 de réalisation d'un empilement Emp de couches le long d'une direction Z sur un substrat Sub telles que décrites précédemment. L'empilement Emp comprend donc :

Sub/Ccont'/Cabs/Eint/Ccont/Cpass

Lors de la réalisation des couches Ccont et Csup, c'est à dire pendant la croissance, les matériaux M2 et M3 sont configurés pour présenter un dopage du premier type. Ce dopage peut être résiduel ou volontaire.

Les couches semiconductrices de l'empilement Emp (c'est à dire toutes les couches sauf Cpass) sont typiquement réalisées par Epitaxie par faisceau moléculaire dénommé MBE (« Molecular Beam Epitaxy » en anglais) ou MOVPE.

Le procédé 30 comprend également une étape 200 de formation d'ouvertures Op dans la couche de passivation Cpass par gravure ionique réactive dénommé RIE (« reactive Ion Etching » en anglais) ou par plasma couplé par induction dénommé ICP (Inductively Coupled Plasma).

Il comprend également une étape 300 d'incorporation d'atomes dopants Ad dans la première couche de contact

Ccont et dans la couche supérieure Csup via les ouvertures Op, de manière à former les zones de détection Zdet présentant un deuxième type de dopage. Les matériaux M2 M3 présentent alors un dopage du deuxième type dans les zones de détection Zdet et un dopage du premier type dans les zones de séparation dans lesquelles les atomes Ad n'ont pas été incorporés.

Enfin le procédé 30 comprend une étape 400 de métallisation au travers des ouvertures Op pour former une première électrode E1.

Préférentiellement l'étape 300 d'incorporation d'atomes dopants s'effectue par diffusion. La présence de la couche Csup permet de faire rentrer une plus grande quantité d'atomes dopants dans la couche Ccont. Selon une option la diffusion s'effectue par ampoule scellée et selon une autre option par MOVPE sous flux pur d'hydrogène ou d'azote (envoi de l'élément V et de l'atome dopant).

Alternativement l'étape 300 s'effectue par implantation ionique.

Préférentiellement le premier type de dopage est n et l'atome dopant incorporé est le Zinc.

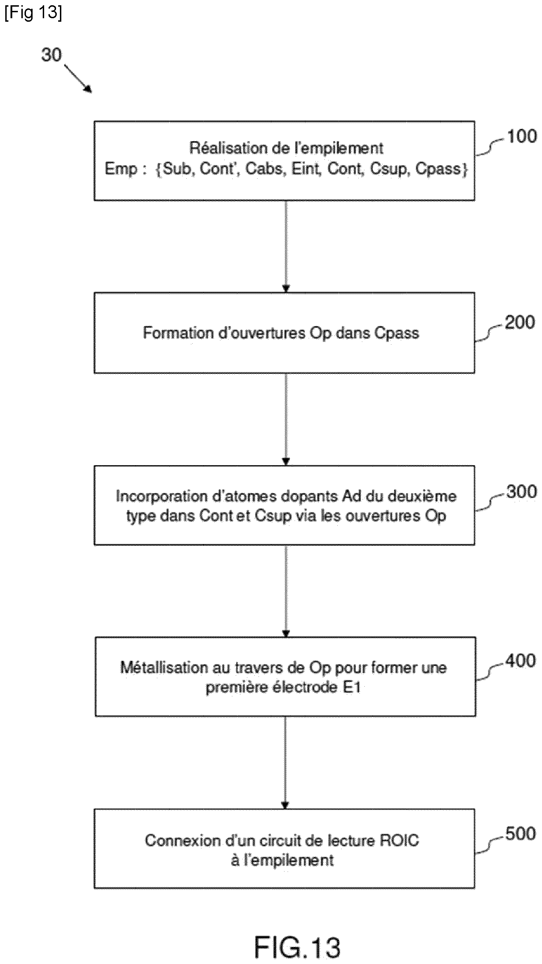

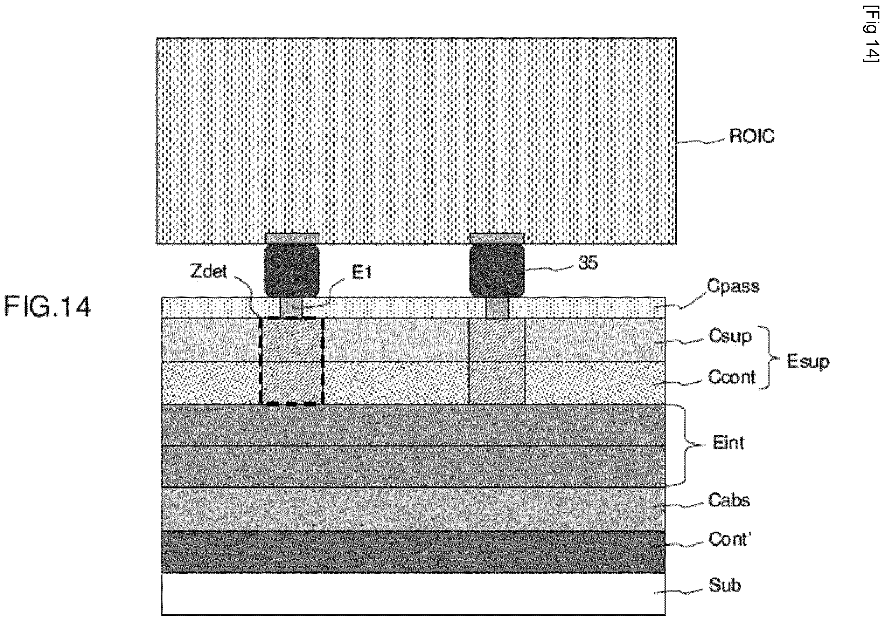

Selon une première variante illustrée figure 13 le procédé 30 comprend en outre, après l'étape de 400 métallisation, une étape 500 de connexion d'un circuit de lecture ROIC audit empilement via la première électrode E1. Cette étape de connexion est classiquement dénommée hybridation. La figure 14 illustre le détecteur de rayonnement ainsi réalisé. L'hybridation s'effectue par exemple avec des billes d'indium 35 en contact avec E1. L'autre électrode E2 (non représentée) est par exemple réalisée par un trou métallisé (« via hole ») qui traverse tout l'empilement jusqu'à Ccont', de manière à constituer une électrode commune à tous les pixels.

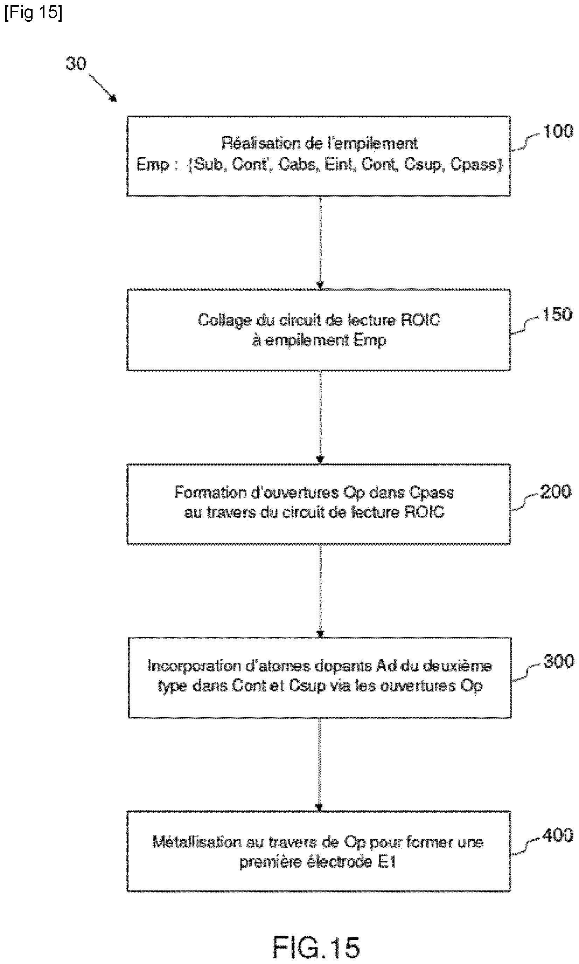

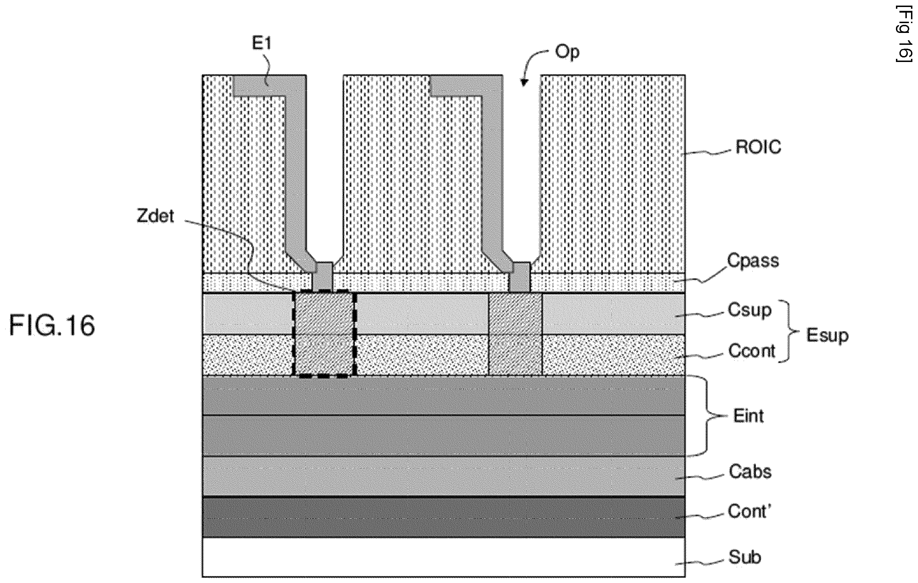

Selon une deuxième variante illustrée figure 15 le procédé 30 comprend en outre, après l'étape de réalisation de l'empilement, une étape 150 de collage d'un circuit de lecture ROIC audit empilement. Le collage s'effectue typiquement par collage direct diélectrique/diélectrique. L'étape 200 de formation des ouvertures Op s'effectue alors au travers du circuit de lecture ROIC, et la métallisation pour la réalisation de la première électrode E1 traverse également le circuit ROIC. La figure 16 illustre le détecteur de rayonnement ainsi réalisé. Un procédé décrivant une pixellisation par diffusion et un collage entre un empilement et un circuit ROIC pour réaliser un détecteur, utilisant des trous au travers du silicium et dénommé TSV pour « Through Silicon Via » en anglais, est par exemple décrit dans le document FR1601066.

**Revendications**

1. Détecteur de rayonnement (10) comprenant un empilement (Emp) de couches le long d'une direction Z, ledit empilement comprenant :

- une couche absorbante (Cabs) configurée pour absorber le rayonnement et réalisée en un premier matériau (M1) semiconducteur présentant un premier gap (G1) et un dopage d'un premier type (t1),
- une première couche de contact (Ccont) réalisée en un deuxième matériau (M2) présentant un deuxième gap (G2) strictement supérieur au premier gap(G1),
- un ensemble d'au moins une couche intermédiaire (Cint, Cinti) dénommé ensemble intermédiaire (Eint), disposé entre la couche absorbante et la première couche de contact, chaque couche intermédiaire (Cint, Cinti) étant réalisée en un matériau intermédiaire (Mint, Minti) semiconducteur présentant un gap intermédiaire (Gint, Ginti) supérieur ou égal au premier gap (G1),
- une couche supérieure (Csup) disposée sur la première couche de contact (Ccont) du côté opposé audit ensemble intermédiaire, réalisée en un troisième matériau (M3) semiconducteur présentant un troisième gap (G3) strictement supérieur à tous les autres gaps de l'empilement,
- la première couche de contact et la couche supérieure présentant une pluralité de zones de détection (Zdet) et de zones de séparation (Zsep), une zone de séparation séparant une zone de détection d'une autre zone de détection, chaque zone de détection étant entourée par une zone de séparation dans un plan perpendiculaire à Z, une zone de détection correspondant à un pixel dudit détecteur, les deuxième (M2) et troisième (M3) matériaux étant configurés pour présenter un dopage d'un deuxième type (t2) dans les zones de détection (Zdet) et un dopage du premier type (t1) dans les zones de séparation (Zsep),
- lorsque le premier type de dopage est n, une bande de valence (BVabs) du premier matériau (M1) est strictement inférieure à une bande de valence (BVcont) du deuxième matériau (M2) dans les zones de détection, et la ou les bandes de valence du ou des matériaux intermédiaires (BVinti) sont comprise(s) entre la bande de valence du premier matériau (BVabs) et la bande de valence du deuxième matériau (BVcont) dans les zones de détection, et sont configurée(s) pour varier de manière monotone croissante dans le sens couche absorbante (Cabs) vers première couche de contact (Ccont),
- lorsque le premier type de dopage est p, une bande de conduction (BCabs) du premier matériau (M1) est strictement supérieure à une bande de conduction du deuxième matériau (BCcont) dans les zones de détection, et la ou les bandes de conduction (BCinti) du ou des matériaux intermédiaires (Mint) sont comprise(s) entre la bande de conduction du premier matériau (BCabs) et la bande de conduction du deuxième matériau (BCcont) dans les zones de détection , et sont configurée(s) pour varier de manière monotone décroissante dans le sens couche absorbante (Cabs) vers première couche de contact (Ccont),
- une couche de passivation (Cpass) réalisée en un matériau diélectrique (Mdiel), disposée sur la couche supérieure (Csup), et présentant des ouvertures (Op) au niveau des zones de détection de la couche supérieure,
- les couches semiconductrices de l'empilement étant des composés à base d'éléments des colonnes IIIA et VA du tableau périodique des éléments, le deuxième matériau (M2) comprenant l'élément VA antimoine (Sb) et le troisième matériau (M3) étant dépourvue de l'élément VA antimoine (Sb).

2. Détecteur selon la revendication précédente dans lequel lorsque le premier type de dopage est n, la ou les bande(s) de valence (BVint) du ou des matériaux intermédiaires (Mint, Minti) sont inférieure(s) à la bande de conduction (BCcont) du deuxième matériau (M2),
et dans lequel lorsque le premier type de dopage est p, la ou les bande(s) de conduction du ou des matériaux intermédiaires sont supérieure(s) à la bande de valence du deuxième matériau (BVcont).

3. Détecteur de rayonnement selon l'une des revendications précédentes dans lequel à l'interface (12) entre la couche supérieure et la couche de contact dans les zones de détection,

lorsque le premier type de dopage est n, la bande de valence du troisième matériau (BVsup) est située en dessous de la bande de valence du deuxième matériau (BVcont) et la bande de conduction du troisième matériau (BCsup) est située au-dessus de la bande de conduction du deuxième matériau (BCcont),
et lorsque le premier type de dopage est p, la bande de conduction du troisième matériau (BCsup) est située au-dessus de la bande de conduction du deuxième matériau (BCcont) et la bande de valence du troisième matériau (BVsup) est située en dessous de la bande de valence du deuxième matériau (BVcont).

4. Détecteur de rayonnement selon l'une des revendications précédentes dans lequel le troisième matériau (M3) est de type III-As.

5. Détecteur de rayonnement selon l'une des revendications précédentes dans lequel le deuxième matériau (M2) est GaSb et le troisième matériau (M3) est InGaAs.

6. Détecteur selon la revendication précédente dans lequel le pourcentage d'indium du troisième matériau est inférieur à 50%.

7. Détecteur de rayonnement selon l'une des revendications précédentes comprenant en outre :

- une deuxième couche de contact (Ccont') disposée sous la couche absorbante et du côté opposé à la couche intermédiaire, réalisée en un quatrième matériau (M4) semiconducteur présentant un quatrième gap (G4) strictement supérieur au premier gap (G1) et un dopage du premier type,
- un substrat (Sub) sur lequel est déposée la deuxième couche de contact (Ccont').

8. Détecteur de rayonnement selon l'une des revendications précédentes dans lequel le dopage de deuxième type des zones de détection est obtenu par une incorporation d'atomes dopants (Ad) dans la couche de contact et la couche supérieure, effectuée postérieurement à la croissance desdites couche de contact et couche supérieure, et via lesdites ouvertures.

9. Détecteur de rayonnement selon la revendication précédente dans lequel la couche supérieure (Csup) et la première couche de contact (Ccont) présentent, dans les zones de détection, et sur toute leur épaisseur respective, une quantité d'atomes dopants (Ad) supérieure à $10^{17}$ atomes/cm$^3$.

10. Procédé (30) de réalisation d'un détecteur de rayonnement comprenant :

- une étape (100) de réalisation d'un empilement (Emp) de couches le long d'une direction Z sur un substrat (Sub) comprenant :

--une couche absorbante (Cabs) configurée pour absorber le rayonnement et réalisée en un premier matériau (M1) semiconducteur présentant un premier gap (G1) et un dopage d'un premier type (t1),
--une première couche de contact (Ccont) réalisée en un deuxième matériau (M2) présentant un deuxième gap (G2) strictement supérieur au premier gap(G1),

-- une deuxième couche de contact (Ccont') réalisée en un quatrième matériau (M4) semiconducteur présentant un quatrième gap (G4) strictement supérieur au premier gap (G1) et un dopage du premier type, disposée entre le substrat et la couche absorbante,

-- un ensemble d'au moins une couche intermédiaire (Cint, Cinti) dénommé ensemble intermédiaire (Eint), disposé entre la couche absorbante et la première couche de contact, chaque couche intermédiaire (Cint, Cinti) étant réalisée en un matériau intermédiaire (Mint, Minti) semiconducteur présentant un gap intermédiaire (Gint, Ginti) supérieur au premier gap (G1),

-- une couche supérieure (Csup) disposée sur la première couche de contact (Ccont) du côté opposé audit ensemble intermédiaire, réalisée en un troisième matériau (M3) semiconducteur présentant un troisième gap (G3) strictement supérieur à tous les autres gaps de l'empilement,

-- une couche de passivation (Cpass) réalisée en un matériau diélectrique (Mdiel), disposée sur la couche supérieure (Csup),

-- les couches semiconductrices de l'empilement étant des composés à base d'éléments des colonnes IIIA et VA du tableau périodique des éléments, le deuxième matériau (M2) comprenant l'élément VA antimoine (Sb) et le troisième matériau (Csup) étant dépourvu de l'élément VA antimoine (Sb),

-- le deuxième et troisième matériau étant configurés pour présenter un dopage du premier type,

-- lorsque le premier type de dopage est n, une bande de valence (BVabs) du premier matériau (M1) est strictement inférieure à une bande de valence (BVcont) du deuxième matériau (M2) dans les zones de détection, lorsque le premier type de dopage est p, une bande de conduction (BCabs) du premier matériau (M1) est strictement supérieure à une bande de conduction du deuxième matériau (BCcont) dans les zones de détection,

- une étape (200) de formation d'ouvertures (Op) dans la couche de passivation (Cpass),

- une étape (300) d'incorporation d'atomes dopants (Ad) dans la première couche de contact (Ccont) et dans la couche supérieure (Csup) via les ouvertures (Op), de manière à former des zones de détection (Zdet) présentant un deuxième type de dopage, les zones de détection étant séparées par des zones de séparation (Zsep) séparant une zone de détection d'une autre zone de détection, chaque zone de détection étant entourée par une zone de séparation dans un plan perpendiculaire à Z, une zone de détection correspondant à un pixel dudit détecteur, les deuxième (M2) et troisième (M3) matériaux présentant alors un dopage du deuxième type (t2) dans les zones de détection (Zdet) et un dopage du premier type (t1) dans les zones de séparation (Zsep),

lorsque le premier type de dopage est n, la ou les bandes de valence du ou des matériaux intermédiaires (BVinti) étant comprise(s) entre la bande de valence du premier matériau (BVabs) et la bande de valence du deuxième matériau (BVcont) dans les zones de détection, et étant configurée(s) pour varier de manière monotone croissante dans le sens couche absorbante (Cabs) vers la première couche de contact (Ccont), lorsque le premier type de dopage est p, la ou les bandes de conduction (BCinti) du ou des matériaux intermédiaires (Mint) étant comprise(s) entre la bande de conduction du premier matériau (BCabs) et la bande de conduction du deuxième matériau (BCcont) dans les zones de détection, et étant configurée(s) pour varier de manière monotone décroissante dans le sens couche absorbante (Cabs) vers la première couche de contact (Ccont),

- une étape (400) de métallisation au travers des ouvertures (Op) pour former une première électrode (E1).

**11.** Procédé selon la revendication précédente dans lequel l'étape d'incorporation d'atomes dopants s'effectue par diffusion.

**12.** Procédé selon l'une des revendications 10 ou 11 dans lequel le premier type de dopage est n et l'atome dopant incorporé est le Zinc.

**13.** Procédé selon l'une des revendications 10 à 12 comprenant en outre, après l'étape de métallisation, une étape (500) de connexion d'un circuit de lecture (ROIC) audit empilement via ladite première électrode (E1).

**14.** Procédé selon l'une des revendications 10 à 12 comprenant en outre, après l'étape de réalisation de l'empilement, une étape (150) de collage d'un circuit de lecture (ROIC) audit empilement, l'étape (200) de formation des ouvertures s'effectuant alors au travers du circuit de lecture.

**Patentansprüche**

1. Strahlungsdetektor (10), der einen Stapel (Emp) von Schichten entlang einer Z-Richtung umfasst, wobei der Stapel Folgendes umfasst:

   - eine Absorptionsschicht (Cabs), die zum Absorbieren der Strahlung konfiguriert und aus einem ersten Halbleitermaterial (M1) mit einer ersten Lücke (G1) und einer Dotierung eines ersten Typs (t1) hergestellt ist,
   - eine aus einem zweiten Material (M2) hergestellte erste Kontaktschicht (Ccont) mit einer zweiten Lücke (G2), die strikt größer als die erste Lücke (G1) ist,
   - einen Satz von mindestens einer Zwischenschicht (Cint, Cinti), Zwischensatz (Eint) genannt, der zwischen der Absorptionsschicht und der ersten Kontaktschicht angeordnet ist, wobei jede Zwischenschicht (Cint, Cinti) aus einem Halbleiterzwischenmaterial (Mint, Minti) mit einer Zwischenlücke (Gint, Ginti) hergestellt ist, die größer als die oder gleich der erste(n) Lücke (G1) ist,
   - eine obere Schicht (Csup), die auf der ersten Kontaktschicht (Ccont) auf der dem Zwischensatz gegenüberliegenden Seite angeordnet ist und aus einem dritten Halbleitermaterial (M3) mit einer dritten Lücke (G3) hergestellt ist, die strikt größer ist als alle anderen Lücken des Stapels,
   - wobei die erste Kontaktschicht und die obere Schicht eine Vielzahl von Detektionszonen (Zdet) und Trennzonen (Zsep) aufweisen, wobei eine Trennzone eine Detektionszone von einer anderen Detektionszone trennt, wobei jede Detektionszone in einer Ebene lotrecht zu Z von einer Trennzone umgeben ist, wobei eine Detektionszone einem Pixel des Detektors entspricht, wobei das zweite (M2) und dritte (M3) Material so konfiguriert sind, dass sie in den Detektionszonen (Zdet) eine Dotierung eines zweiten Typs (t2) und in den Trennzonen (Zsep) eine Dotierung des ersten Typs (t1) aufweisen,
   - wenn der erste Dotierungstyp n ist, ein Valenzband (BVabs) des ersten Materials (M1) in den Detektionszonen strikt kleiner ist als ein Valenzband (BVcont) des zweiten Materials (M2), und das Valenzband oder die Valenzbänder des Zwischenmaterials oder der Zwischenmaterialien (BVinti) zwischen dem Valenzband des ersten Materials (BVabs) und dem Valenzband des zweiten Materials (BVcont) in den Detektionszonen liegt/liegen und zum monoton zunehmenden Variieren in der Richtung von der Absorptionsschicht (Cabs) zur ersten Kontaktschicht (Ccont) konfiguriert ist/sind,
   - wenn der erste Dotierungstyp p ist, ein Leitungsband (BCabs) des ersten Materials (M1) in den Detektionszonen strikt höher ist als ein Leitungsband des zweiten Materials (BCcont), und das Leitungsband oder die Leitungsbänder (BCinti) des Zwischenmaterials oder der Zwischenmaterialien (Mint) zwischen dem Leitungsband des ersten Materials (BCabs) und dem Leitungsband des zweiten Materials (BCcont) in den Detektionszonen liegt/liegen und zum monoton abnehmenden Variieren in der Richtung von der Absorptionsschicht (Cabs) zur ersten Kontaktschicht (Ccont) konfiguriert ist/sind,
   - wobei eine aus dielektrischem Material (Mdiel) hergestellte Passivierungsschicht (Cpass) auf der oberen Schicht (Csup) angeordnet ist und Öffnungen (Op) in den Detektionszonen der oberen Schicht aufweist,
   - wobei die Halbleiterschichten des Stapels aus Verbindungen auf der Basis von Elementen der Spalten IIIA und VA des Periodensystems der Elemente bestehen, wobei das zweite Material (M2) das Element VA Antimon (Sb) umfasst und das dritte Material (M3) frei von dem Element VA Antimon (Sb) ist.

2. Detektor nach dem vorhergehenden Anspruch, wobei, wenn der erste Dotierungstyp n ist, das Valenzband oder die Valenzbänder (BVint) des Zwischenmaterials oder der Zwischenmaterialien (Mint, Minti) kleiner als das Leitungsband (BCcont) des zweiten Materials (M2) ist/sind,
   und wobei, wenn der erste Dotierungstyp p ist, das Leitungsband oder die Leitungsbänder des Zwischenmaterials oder der Zwischenmaterialien höher als das Valenzband des zweiten Materials (BVcont) ist/sind.

3. Strahlungsdetektor nach einem der vorhergehenden Ansprüche, wobei an der Grenzfläche (12) zwischen der oberen Schicht und der Kontaktschicht in den Detektionszonen,

   wenn der erste Dotierungstyp n ist, das Valenzband des dritten Materials (BVsup) unterhalb des Valenzbandes des zweiten Materials (BVcont) liegt und das Leitungsband des dritten Materials (BCsup) oberhalb des Leitungsbands des zweiten Materials (BCcont) liegt,
   und wenn der erste Dotierungstyp p ist, das Leitungsband des dritten Materials (BCsup) oberhalb des Leitungsbands des zweiten Materials (BCcont) liegt und das Valenzband des dritten Materials (BVsup) unterhalb des Valenzbandes des zweiten Materials (BVcont) liegt.

4. Strahlungsdetektor nach einem der vorhergehenden Ansprüche, wobei das dritte Material (M3) vom Typ III-As ist.

5. Strahlungsdetektor nach einem der vorhergehenden Ansprüche, wobei das zweite Material (M2) GaSb ist und das dritte Material (M3) InGaAs ist.

6. Detektor nach dem vorhergehenden Anspruch, wobei der Indiumanteil des dritten Materials weniger als 50% beträgt.

7. Strahlungsdetektor nach einem der vorhergehenden Ansprüche, der ferner Folgendes umfasst:

- eine zweite Kontaktschicht (Ccont'), die unter der Absorptionsschicht und auf der der Zwischenschicht gegenüberliegenden Seite angeordnet ist und aus einem vierten Halbleitermaterial (M4) mit einer vierten Lücke (G4), die strikt größer als die erste Lücke (G1) ist, und einer Dotierung des ersten Typs hergestellt ist,
- ein Substrat (Sub), auf das die zweite Kontaktschicht (Ccont') aufgebracht wird.

8. Strahlungsdetektor nach einem der vorhergehenden Ansprüche, wobei die Dotierung des zweiten Typs der Detektionszonen durch Einbauen von Dotierungsatomen (Ad) in die Kontaktschicht und die obere Schicht erreicht wird, was nach dem Wachstum der Kontaktschicht und der oberen Schicht und durch die Öffnungen erfolgt.

9. Strahlungsdetektor nach dem vorhergehenden Anspruch, wobei die obere Schicht (Csup) und die erste Kontaktschicht (Ccont) in den Detektionszonen und über ihre jeweilige gesamte Dicke eine Menge an Dotierungsatomen (Ad) aufweisen, die größer als $10^{17}$ Atome/cm$^3$ ist.

10. Verfahren (30) zur Herstellung eines Strahlungsdetektors, das Folgendes umfasst:

- einen Schritt (100) des Herstellens eines Stapels (Emp) von Schichten entlang einer Z-Richtung auf einem Substrat (Sub), der Folgendes umfasst:

- eine Absorptionsschicht (Cabs), die zum Absorbieren der Strahlung ausgelegt und aus einem ersten Halbleitermaterial (M1) mit einer ersten Lücke (G1) und einer Dotierung eines ersten Typs (t1) hergestellt ist,
- eine aus einem zweiten Material (M2) hergestellte erste Kontaktschicht (Ccont) mit einer zweiten Lücke (G2), die strikt größer ist als die erste Lücke (G1),
- eine aus einem vierten Halbleitermaterial (M4) hergestellte zweite Kontaktschicht (Ccont') mit einer vierten Lücke (G4), die strikt größer ist als die erste Lücke (G1), und einer Dotierung des ersten Typs, die zwischen dem Substrat und der Absorptionsschicht angeordnet ist,
- einen Satz von mindestens einer Zwischenschicht (Cint, Cinti), Zwischensatz (Eint) genannt, der zwischen der Absorptionsschicht und der ersten Kontaktschicht angeordnet ist, wobei jede Zwischenschicht (Cint, Cinti) aus einem Zwischenhalbleitermaterial (Mint, Mintj) mit einer Zwischenlücke (Gint, Ginti) hergestellt ist, die größer als die erste Lücke (G1) ist,
- eine obere Schicht (Csup), die auf der ersten Kontaktschicht (Ccont) auf der dem Zwischensatz gegenüberliegenden Seite angeordnet ist und aus einem dritten Halbleitermaterial (M3) mit einer dritten Lücke (G3) hergestellt ist, die strikt größer ist als alle anderen Lücken des Stapels,
- eine aus einem dielektrischen Material (Mdiel) hergestellte Passivierungsschicht (Cpass), die auf der oberen Schicht (Csup) angeordnet ist,
- wobei die Halbleiterschichten des Stapels aus Verbindungen auf der Basis von Elementen der Spalten IIIA und VA des Periodensystems der Elemente bestehen, wobei das zweite Material (M2) das Element VA Antimon (Sb) umfasst und das dritte Material (Csup) frei von dem Element VA Antimon (Sb) ist,
- wobei das zweite und das dritte Material so konfiguriert sind, dass sie eine Dotierung des ersten Typs aufweisen,
- wenn der erste Dotierungstyp n ist, ein Valenzband (BVabs) des ersten Materials (M1) in den Detektionszonen strikt kleiner als ein Valenzband (BVcont) des zweiten Materials (M2) ist, wenn der erste Dotierungstyp p ist, ein Leitungsband (BCabs) des ersten Materials (M1) in den Detektionszonen strikt größer als ein Leitungsband des zweiten Materials (BCcont) ist,
- einen Schritt (200) des Bildens von Öffnungen (Op) in der Passivierungsschicht (Cpass),
- einen Schritt (300) des Einbauens von Dotierungsatomen (Ad) in die erste Kontaktschicht (Ccont) und in die obere Schicht (Csup) durch die Öffnungen (Op), um Detektionszonen (Zdet) zu bilden, die einen zweiten Dotierungstyp aufweisen, wobei die Detektionszonen durch Trennzonen (Zsep) getrennt sind, die eine Detektionszone von einer anderen Detektionszone trennen, wobei jede Detektionszone von einer Trennzone in einer Ebene lotrecht zu Z umgeben ist, wobei eine Detektionszone einem Pixel des Detektors entspricht, wobei das zweite (M2) und dritte (M3) Material dann in den Detektionszonen (Zdet) eine Dotierung des zweiten Typs (t2) und in den Trennzonen (Zsep) eine Dotierung des ersten Typs (t1) aufweisen,

wenn der erste Dotierungstyp n ist, das Valenzband oder die Valenzbänder des Zwischenmaterials oder der Zwischenmaterialien (BVinti) zwischen dem Valenzband des ersten Materials (BVabs) und dem Valenzband des zweiten Materials (BVcont) in den Detektionszonen liegt/liegen und zum monoton zunehmenden Variieren in der Richtung von der Absorptionsschicht (Cabs) zur ersten Kontaktschicht (Ccont) konfiguriert ist/sind,

wenn der erste Dotierungstyp p ist, das Leitungsband oder die Leitungsbänder (BCinti) des Zwischenmaterials oder der Zwischenmaterialien (Mint) zwischen dem Leitungsband des ersten Materials (BCabs) und dem Leitungsband des zweiten Materials (BCcont) in den Detektionszonen liegt/liegen und zum monoton abnehmenden Variieren in der Richtung von der Absorptionsschicht (Cabs) zur ersten Kontaktschicht (Ccont) konfiguriert ist/sind,

- einen Schritt (400) des Metallisierens durch die Öffnungen (Op), um eine erste Elektrode (E1) zu bilden.

**11.** Verfahren nach dem vorhergehenden Anspruch, wobei der Schritt des Einbauens von Dotierungsatomen durch Diffusion erfolgt.

**12.** Verfahren nach einem der Ansprüche 10 oder 11, wobei der erste Dotierungstyp n ist und das eingebaute Dotierungsatom Zink ist.

**13.** Verfahren nach einem der Ansprüche 10 bis 12, das ferner nach dem Metallisierungsschritt einen Schritt (500) des Verbindens einer Leseschaltung (ROIC) mit dem Stapel über die erste Elektrode (E1) umfasst.

**14.** Verfahren nach einem der Ansprüche 10 bis 12, das ferner nach dem Schritt des Herstellens des Stapels einen Schritt (150) des Klebens einer Leseschaltung (ROIC) an den Stapel umfasst, wobei der Schritt (200) des Bildens der Öffnungen dann durch die Leseschaltung hindurch erfolgt.

**Claims**

**1.** A radiation detector (10) comprising a stack (Emp) of layers along a direction Z, said stack comprising:

- an absorbent layer (Cabs) configured to absorb the radiation and made from a first semiconductor material (M1) having a first gap (G1) and doping of a first type (t1),
- a first contact layer (Ccont) made from a second material (M2) having a second gap (G2) strictly greater than the first gap (G1),
- an assembly consisting of at least one intermediate layer (Cint, Cinti), referred to as an intermediate assembly (Eint), arranged between the absorbent layer and the first contact layer, each intermediate layer (Cint, Cinti) being made from an intermediate semiconductor material (Mint, Minti) having an intermediate gap (Gint, Ginti) greater than or equal to the first gap (G1),
- an upper layer (Csup) arranged on the first contact layer (Ccont) on the opposite side from said intermediate assembly, made from a third semiconductor material (M3) having a third gap (G3) strictly greater than all the other gaps of the stack,
- the first contact layer and the upper layer having a plurality of detection zones (Zdet) and separation zones (Zsep), a separation zone separating one detection zone from another detection zone, each detection zone being surrounded by a separation zone in a plane perpendicular to Z, a detection zone corresponding to a pixel of said detector, the second (M2) and third (M3) materials being configured to have doping of a second type (t2) in the detection zones (Zdet) and doping of the first type (t1) in the separation zones (Zsep),
- when the first doping type is n, a valence band (BVabs) of the first material (M1) is strictly less than a valence band (BVcont) of the second material (M2) in the detection zones, and the valence band or bands (BVinti) of the intermediate material or materials lie between the valence band of the first material (BVabs) and the valence band of the second material (BVcont) in the detection zones, and are configured to vary monotonically increasingly in the direction from the absorbent layer (Cabs) toward the first contact layer (Ccont),
- when the first doping type is p, a conduction band (BCabs) of the first material (M1) is strictly greater than a conduction band of the second material (BCcont) in the detection zones, and the conduction band or bands (BCinti) of the intermediate material or materials (Mint) lie between the conduction band of the first material (BCabs) and the conduction band of the second material (BCcont) in the detection zones, and are configured to vary monotonically decreasingly in the direction from the absorbent layer (Cabs) toward the first contact layer (Ccont),

- a passivation layer (Cpass) made from a dielectric material (Mdiel), arranged on the upper layer (Csup) and having openings (Op) at the level of the detection zones of the upper layer,
- the semiconductor layers of the stack being compounds based on elements of columns IIIA and VA of the periodic table of the elements, the second material (M2) comprising the VA element antimony (Sb) and the third material (M3) not comprising the VA element antimony (Sb).

2. The detector according to the preceding claim, wherein when the first doping type is n, the valence band(s) (BVint) of the intermediate material or materials (Mint, Minti) are less than the conduction band (BCcont) of the second material (M2),

and wherein when the first doping type is p, the conduction band(s) of the intermediate material or materials are greater than the valence band of the second material (BVcont).

3. The radiation detector according to one of the preceding claims, wherein at the interface (12) between the upper layer and the contact layer in the detection zones,

when the first doping type is n, the valence band of the third material (BVsup) lies below the valence band of the second material (BVcont) and the conduction band of the third material (BCsup) lies above the conduction band of the second material (BCcont),

and when the first doping type is p, the conduction band of the third material (BCsup) lies above the conduction band of the second material (BCcont) and the valence band of the third material (BVsup) lies below the valence band of the second material (BVcont).

4. The radiation detector according to one of the preceding claims, wherein the third material (M3) is of the type III-As.

5. The radiation detector according to one of the preceding claims, wherein the second material (M2) is GaSb and the third material (M3) is InGaAs.

6. The detector according to the preceding claim, wherein the percentage of indium of the third material is less than 50%.

7. The radiation detector according to one of the preceding claims, further comprising:

- a second contact layer (Ccont') arranged below the absorbent layer and on the opposite side from the intermediate layer, made from a fourth semiconductor material (M4) having a fourth gap (G4) strictly greater than the first gap (G1) and doping of the first type,
- a substrate (Sub) on which the second contact layer (Ccont') is deposited.

8. The radiation detector according to one of the preceding claims, wherein the doping of the second type of the detection zones is obtained by incorporation of dopant atoms (Ad) into the contact layer and the upper layer, which is carried out after the growth of said contact layer and upper layer, and via said openings.

9. The radiation detector according to the preceding claim, wherein the upper layer (Csup) and the first contact layer (Ccont) have, in the detection zones and over their entire respective thickness, a quantity of dopant atoms (Ad) greater than $10^{17}$ atoms/cm$^3$.

10. A method (30) for producing a radiation detector, comprising:

- a step (100) of producing a stack (Emp) of layers along a direction Z on a substrate (Sub), comprising:

- an absorbent layer (Cabs) configured to absorb the radiation and made from a first semiconductor material (M1) having a first gap (G1) and doping of a first type (t1),
- a first contact layer (Ccont) made from a second material (M2) having a second gap (G2) strictly greater than the first gap (G1),
- a second contact layer (Ccont') made from a fourth semiconductor material (M4) having a fourth gap (G4) strictly greater than the first gap (G1) and doping of the first type, arranged between the substrate and the absorbent layer,
- an assembly consisting of at least one intermediate layer (Cint, Cinti), referred to as an intermediate assembly (Eint), arranged between the absorbent layer and the first contact layer, each intermediate layer (Cint, Cinti) being made from an intermediate semiconductor material (Mint, Minti) having an intermediate gap (Gint, Ginti) greater than the first gap (G1),
- an upper layer (Csup) arranged on the first contact layer (Ccont) on the opposite side from said intermediate assembly, made from a third semiconductor material (M3) having a third gap (G3) strictly greater than all the other gaps of the stack,
- a passivation layer (Cpass) made from a dielectric material (Mdiel), arranged on the upper layer (Csup),
- the semiconductor layers of the stack being compounds based on elements of columns IIIA and VA of the periodic table of the elements, the second material (M2) comprising the VA element antimony (Sb) and the third material (Csup) not comprising the VA element antimony (Sb),
- the second and third materials being configured to have doping of the first type,
- when the first doping type is n, a valence band (BVabs) of the first material (M1) is strictly less than a valence band (BVcont) of the second material (M2) in the detection zones, when the first doping type is p, a conduction band (BCabs) of the first material (M1) is strictly greater than a conduction band (BCcont) of the second material in the detection zones,
- a step (200) of forming openings (Op) in the passivation layer (Cpass),
- a step (300) of incorporating dopant atoms (Ad) into the first contact layer (Ccont) and into the upper layer (Csup) via the openings (Op), so as to form detection zones (Zdet) having a second doping type, the detection zones being separated by separation zones (Zsep) separating one detection zone from another detection zone, each detection zone being surrounded by a separation zone in a plane perpendicular to Z, a detection zone corresponding to a pixel of said detector, the second (M2) and third (M3) materials then having doping of the second type (t2) in the detection zones (Zdet) and doping of the first type (t1) in the separation zones (Zsep),

when the first doping type is n, the valence band or bands of the intermediate material or materials (BVinti) lying between the valence band of the first material (BVabs) and the valence band of the second material (BVcont) in the detection zones, and being configured to vary monotonically increasingly in the direction from the absorbent layer (Cabs) toward the first contact layer (Ccont),
when the first doping type is p, the conduction band or bands (BCinti) of the intermediate material or materials (Mint) lying between the conduction band of the first material (BCabs) and the conduction band of the second material (BCcont) in the detection zones, and being configured to vary monotonically decreasingly in the direction from the absorbent layer (Cabs) toward the first contact layer (Ccont),

- a step (400) of metallisation through the openings (Op) in order to form a first electrode (E1).

11. The method according to the preceding claim, wherein the step of incorporating dopant atoms is carried out by diffusion.

12. The method according to one of claims 10 and 11, wherein the first doping type is n and the dopant atom incorporated is zinc.

13. The method according to one of claims 10 to 12, further comprising, after the metallisation step, a step (500) of connecting a reading circuit (ROIC) to said stack via said first electrode (E1).

14. The method according to one of claims 10 to 12, further comprising, after the step of producing the stack, a step (150) of bonding a reading circuit (ROIC) to said stack, the step (200) of forming the openings then being carried out through the reading circuit.

[Fig 1]

FIG.1

[Fig 2]

FIG.2

[Fig 3]

FIG.3

[Fig 4]

FIG.4

[Fig 5]

FIG.5

[Fig 6]

FIG.6

[Fig 7]

FIG.7

[Fig 8]

FIG.8

[Fig 9]

FIG.9

[Fig 10]

FIG.10

[Fig 11]

FIG.11

[Fig 12]

30

```
┌─────────────────────────────────────────┐
│   Réalisation de l'empilement            │ ──100
│ Emp : {Sub, Cont', Cabs, Eint, Cont,     │
│                       Csup, Cpass}       │
└─────────────────────────────────────────┘
                    │
                    ▼
┌─────────────────────────────────────────┐
│                                          │ ──200
│   Formation d'ouvertures Op dans Cpass   │
│                                          │
└─────────────────────────────────────────┘
                    │
                    ▼
┌─────────────────────────────────────────┐
│  Incorporation d'atomes dopants Ad du    │ ──300
│  deuxième type dans Cont et Csup via     │
│            les ouvertures Op             │
└─────────────────────────────────────────┘
                    │
                    ▼
┌─────────────────────────────────────────┐
│  Métallisation au travers de Op pour     │ ──400
│  former une première électrode E1        │
└─────────────────────────────────────────┘
```

FIG.12

[Fig 13]

30

```
┌─────────────────────────────────────────────────┐
│         Réalisation de l'empilement              │─ 100
│ Emp : {Sub, Cont', Cabs, Eint, Cont, Csup, Cpass}│
└─────────────────────────────────────────────────┘
                        │
                        ▼
┌─────────────────────────────────────────────────┐
│                                                  │─ 200
│        Formation d'ouvertures Op dans Cpass      │
│                                                  │
└─────────────────────────────────────────────────┘
                        │
                        ▼
┌─────────────────────────────────────────────────┐
│    Incorporation d'atomes dopants Ad du deuxième │─ 300
│      type dans Cont et Csup via les ouvertures Op│
└─────────────────────────────────────────────────┘
                        │
                        ▼
┌─────────────────────────────────────────────────┐
│   Métallisation au travers de Op pour former une │─ 400
│            première électrode E1                 │
└─────────────────────────────────────────────────┘
                        │
                        ▼
┌─────────────────────────────────────────────────┐
│       Connexion d'un circuit de lecture ROIC     │─ 500
│                 à l'empilement                   │
└─────────────────────────────────────────────────┘
```

FIG.13

[Fig 14]

FIG.14

[Fig 15]

30

| Réalisation de l'empilement<br>Emp : {Sub, Cont', Cabs, Eint, Cont, Csup, Cpass} | 100 |

| Collage du circuit de lecture ROIC<br>à empilement Emp | 150 |

| Formation d'ouvertures Op dans Cpass<br>au travers du circuit de lecture ROIC | 200 |

| Incorporation d'atomes dopants Ad du deuxième<br>type dans Cont et Csup via les ouvertures Op | 300 |

| Métallisation au travers de Op pour former une<br>première électrode E1 | 400 |

FIG.15

[Fig 16]

FIG.16

## RÉFÉRENCES CITÉES DANS LA DESCRIPTION

**Documents brevets cités dans la description**

- EP 1642345 A
- EP 2002487 A
- EP 2249400 A
- EP 2797122 A
- FR 1601065
- FR 3053836 A1
- FR 1501985
- FR 3041815 A1
- FR 1601066